# EUROPÄISCHE PATENTSCHRIFT

(11) **EP 1 904 507 B1**
(45) Veröffentlichungstag und Bekanntmachung des Hinweises auf die Patenterteilung: **01.09.2010**
(21) Anmeldenummer: 06754266.2
(22) Anmeldetag: 09.06.2006
(51) Int. Cl.: C07F 15/00

(54) **METALLKOMPLEXE**
METAL COMPLEXES
COMPLEXES METALLIQUES

(30) Priorität: 08.07.2005 DE 102005032332
(43) Veröffentlichungstag der Anmeldung: 02.04.2008
(73) Patentinhaber: Merck Patent GmbH, 64293 Darmstadt (DE)
(72) Erfinder: STOESSEL, Philipp, 60487 Frankfurt am Main (DE); BECKER, Heinrich, 65719 Hofheim (DE); PARHAM, Amir, 65929 Frankfurt (DE); BREUNING, Esther, 65527 Niedernhausen (DE)
(86) Internationale Anmeldenummer: PCT/EP2006/005564
(87) Internationale Veröffentlichungsnummer: WO 2007/006380

(56) Entgegenhaltungen:
- WO-A-96/03409
- WO-A-2005/026144

## Beschreibung

Die vorliegende Erfindung beschreibt neue Materialien, deren Verwendung in elektronischen Bauteilen, insbesondere in Elektrolumineszenzelementen und darauf basierende Displays.

Metallorganische Verbindungen, speziell Ir- und Pt-Verbindungen, finden in einer Reihe verschiedenartiger Anwendungen, die im weitesten Sinne der Elektronikindustrie zugerechnet werden können, Einsatz als funktionelle Materialien, z. B. in organischen Elektrolumineszenzvorrichtungen. Der allgemeine Aufbau solcher Vorrichtungen ist beispielsweise in US 4,539,507 und US 5,151,629 beschrieben.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie-und Leistungseffzienz möglich. Ob sich diese Entwicklung durchsetzen wird, hängt davon ab, ob entsprechende Device-Kompositionen gefunden werden, die diese Vorteile (Triplett-Emission = Phosphoreszenz gegenüber Singulett-Emission = Fluoreszenz) auch in den Elektrolumineszenzvorrichtungen umsetzen können. Als wesentliche Bedingungen sind hier insbesondere eine hohe operative Lebensdauer und eine hohe thermische Stabilität der Komplexe zu nennen. Die meisten in der Literatur bekannten Komplexe sind neutrale Verbindungen. Sie enthalten Liganden, die auf Phenylpyridin oder verwandten Strukturen basieren, die an Iridium oder Platin koordinieren (z. B. WO 02/068435, WO 04/026886). Dabei ist diese Struktur durch die Abwesenheit einer Brücke (Formel A) bzw. die Anwesenheit einer Brücke zwischen den beiden Cyclen (WO 03/000661, Formel B), die 2 - 20 Alkylkohlenstoffatome enthält, die gegebenenfalls durch Heteroatome ersetzt sein können, charakterisiert.

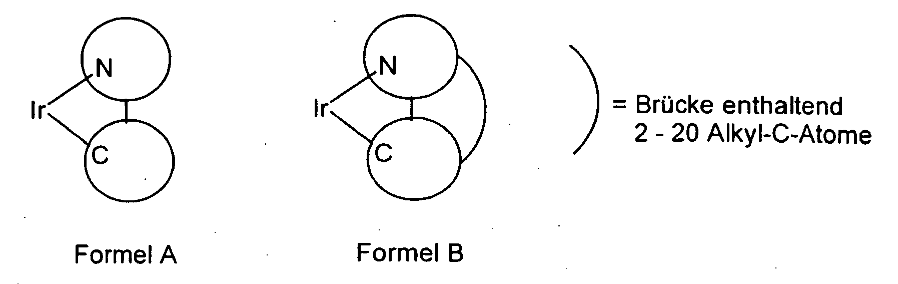

Die oben beschriebenen Komplexe sind in organischen Lösemitteln oftmals sehr schlecht löslich, so dass eine Verarbeitung aus Lösung unmöglich bzw. sehr schwierig ist. Die Verarbeitung aus Lösung ist jedoch aus fertigungstechnischen Gründen sehr wünschenswert, da diese einfacher und kostengünstiger ist als die Verarbeitung unter Hochvakuumbedingungen. Ein Weg zur Verbesserung der Löslichkeit ist in WO 04/026886 ausführlich beschrieben und besteht in der Modifikation der Liganden durch aromatische bzw. aliphatische Reste unter Erhalt neutraler, homoleptischer Komplexe.

WO2005/026144 offenbart (die Verweise in Klammern beziehen sich auf die Übersetzung dieses Dokuments DE 112004 001 675T) in den Beispielen (1-3) nur neutrale Komplexe für Lumineszenzvorrichtungen. Die Komplexe der Beispiele enthalten Liganden, die auf Phenylpyridin-Strukturen basieren.

Überraschend wurde gefunden, dass sich die Löslichkeit homoleptischer Komplexe des o. g. Bautyps, insbesondere in dipolaren und dipolar-protischen Lösungsmitteln durch Einführung anionischer und/oder kationischer Gruppen an den Liganden erheblich steigern lässt, was zu einer exzellenten Verarbeitbarkeit dieser Komplexe aus Lösung führt.

Weiterhin zeigen diese Komplexe eine niedrigere Einsatzspannung bei Verwendung in OLEDs als neutrale Metallkomplexe gemäß dem Stand der Technik.

Gegenstand der vorliegenden Erfindung sind ionische Verbindungen gemäß Formel (1)

[M(L)^{t+/t-}ₙ(L')ₘ(L")ₒ] [Ion]^{t-/t+}ₙ Formel (1)

enthaltend eine Teilstruktur M(L)^{t+/t-}ₙ gemäß Formel (2) als Kation oder Anion, 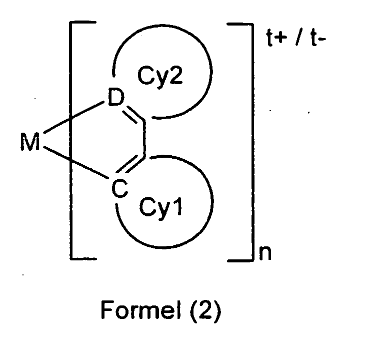 wobei für die verwendeten Symbole und Indizes gilt:
- M: ist bei jedem Auftreten ein Element der ersten bis neunten Neben- gruppe des Periodensystems der Elemente, vorzugsweise Iridium, Rhodium. Platin, Palladium, Gold, Wolfram, Rhenium, Ruthenium oder Osmium;
- D: ist gleich oder verschieden bei jedem Auftreten ein sp²- hybridisiertes Heteroatom mit einem nicht-bindenden Elektronen- paar, das an M koordiniert;
- C: ist bei jedem Auftreten ein sp²-hybridisiertes Kohlenstoffatom, das an M bindet;
- Cy1: ist gleich oder verschieden bei jedem Auftreten ein gegebenenfalls durch R¹ und/oder Q substituierter Homo- oder Heterocyclus, der über ein sp²-hybridisiertes Kohlenstoffatom an M bindet; dabei kann Cy1 sowohl ein Monocyclus wie auch ein Oligocyclus sein;
- Cy2: ist gleich oder verschieden bei jedem Auftreten ein gegebenenfalls durch R¹ und/oder Q substituierter Heterocyclus, der über das Atom D an M koordiniert; dabei kann Cy2 sowohl ein Monocyclus wie auch ein Oligocyclus sein;
- Q: ist gleich oder verschieden bei jedem Auftreten ein positiv oder negativ geladener Substituent mit der Anzahl t an positiven oder negativen Ladungen;
- R¹: ist gleich oder verschieden bei jedem Auftreten H, Deuterium, F, Cl, Br, I, OH, NO₂, CN, N(R²)₂, B(OH)₂, B(OR²)₂, eine geradkettige Alkyl- oder Alkoxygruppe mit 1 bis 40 C-Atomen, eine verzweigte oder cyclische Alkyl- oder Alkoxygruppe mit 3 bis 40 C-Atomen, wobei bei den vorstehend genannten Alkyl- oder Alkoxygruppen jeweils eine oder mehrere nicht benachbarte CH₂-Gruppen durch -R²C=CR²-, -C=C-, Si(R²)₂, Ge(R²)₂, Sn(R²)₂, -O-, -S-, -NR²-, -(C=O)-, -(C=NR¹)-, -P=O(R²)-, -COOR²- oder -CONR²- ersetzt sein können und wobei ein oder mehrere H-Atome durch F ersetzt sein können,
oder
ein aromatisches System mit 6 bis 30 C-Atomen, ein hetero- aromatisches System mit 2 bis 30 C-Atomen bzw. eine Aryloxy- oder Heteroaryloxygruppe der vorgenannten Systeme, welches jeweils durch einen oder mehrere nicht-aromatische Reste R¹ substituiert sein kann, wobei mehrere Substituenten R¹, sowohl am selben Ring als auch an unterschiedlichen Ringen zusammen wiederum ein weiteres mono- oder polycyclisches, aliphatisches oder aromatisches Ringsystem aufspannen können;
- R²: ist gleich oder verschieden bei jedem Auftreten H oder ein aliphatischer Kohlenwasserstoffrest mit 1 bis 20 C-Atomen oder aromatischer Kohlenwasserstoffrest mit 6 bis 20 C-Atomen oder ein heteroaromatischer Kohlenwasserstoffrest mit 2 bis 30 C-Atomen;
- n: ist 1, 2 oder 3;
- t: ist 1, 2 oder 3, vorzugsweise 1 oder 2, insbesondere 1, wobei der Ligand selber die Ladung trägt;
dabei sind die Liganden L' und L" in Formel (1) monoanionische,
zweizähnig chelatisierende Liganden; m und o sind gleich oder
verschieden bei jedem Auftreten 0, 1 oder 2;
**dadurch gekennzeichnet, dass** an der Struktur der Formel (2) mindestens eine Gruppe Q vorhanden ist;
und ein Ion, welches als Gegenion zum Komplexion [M(L)^{t+/t-}ₙ(L')ₘ(L")ₒ] wirkt.

Dabei gilt, dass n + m + o = 2 für quadratisch-planar koordinierte Metalle, beispielsweise Platin und Palladium, und n + m + o = 3 für oktaedrisch koordinierte Metalle, beispielsweise Iridium, ist.

Weiterhin kann der Cyclus Cy2 auch ein Carben sein, welches über Kohlenstoff statt über ein Heteroatom D an das Metall koordiniert, wie beispielsweise in WO 05/019373 beschrieben.

Unter Hybridisierung wird die Linearkombination von Atomorbitalen verstanden. So entstehen durch Linearkombination von einem 2s- und zwei 2p-Orbitalen drei äquivalente sp²-Hybridorbitale, die einen Winkel von 120° miteinander bilden. Das verbleibende p-Orbital ist zur Ausbildung einer n-Bindung, beispielsweise in einem aromatischen System, befähigt.

Die erfindungsgemäßen Verbindungen der Formel (1) können, wenn es sich um oktaedrische Komplexe handelt, facialer oder meridionaler Natur sein, wobei die Unterscheidung zwischen facialen und meridionalen Komplexen nur sinnvoll möglich ist, wenn der Komplex drei Liganden mit jeweils denselben Donoratomen trägt. Gegenstand der Erfindung sind sowohl die rein faciale Form wie auch die rein meridionale Form des Komplexes oder auch Mischungen, in der sowohl die faciale wie auch die meridionale Form vorliegen. Bevorzugt sind faciale Komplexe.

Faciale bzw. meridionale Koordination im Sinne dieser Anmeldung beschreibt die Umgebung des Metalls M mit den sechs Donoratomen. Eine faciale Koordination liegt vor, wenn drei identische Donoratome eine Dreiecksfläche im (pseudo)oktaedrischen Koordinationspolyeder und drei identische, aber von den ersten verschiedene Donoratome eine andere Dreiecksfläche im (pseudo)oktaedrischen Koordinationspolyeder besetzen. Bei einer meridionalen Koordination besetzen drei identische Donoratome den einen Meridian im (pseudo)oktaedrischen Koordinationspolyeder und drei identische, aber von den ersten verschiedene Donoratome den anderen Meridian im (pseudo)oktaedrischen Koordinationspolyeder. Dies ist im Folgenden am Beispiel der Koordination von drei N-Donoratome und drei C-Donoratomen gezeigt (Schema 1). Da sich diese Beschreibung auf Donoratome bezieht und nicht auf die Cyclen Cy1 und Cy2, die diese Donoratome bereitstellen; können die drei Cyclen Cy1 und die drei Cyclen Cy2 bei jedem Auftreten gleich oder verschieden sein und trotzdem einer facialen oder meridionalen Koordination im Sinne dieser Anmeldung entsprechen. Als identische Donoratome werden solche verstanden, die aus den gleichen Elementen (z. B. Stickstoff) bestehen, unabhängig ob diese Elemente in unterschiedliche, gegebenenfalls cyclische Strukturen eingebaut sind.

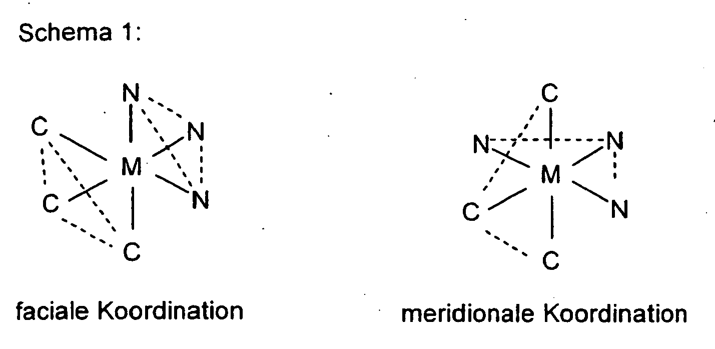

Die erfindungsgemäßen ionischen Verbindungen der Formel (1) bzw. (1 a) können auch als gemischte Salze vorliegen. Enthält die Verbindung der Formel (1) bzw. (1a) eine Teilstruktur M(L)^{t+}ₙ gemäß Formel (2) bzw. (2a) mit einem kationischen Liganden, so kann das Anion aus einer Teilstruktur M(L)^{t-}ₙ gemäß Formel (2) bzw. (2a) mit einem anionischen Liganden als Gegenion gebildet werden. Das zuvor Gesagte gilt auch im umgekehrten Falle, wenn die Verbindung der Formel (1) bzw. (1a) eine Teilstruktur M(L)^{t-}ₙ gemäß Formel (2) bzw. (2a) mit einem anionischen Liganden enthält, so kann das Kation aus einer Teilstruktur M(L)^{t+}ₙ gemäß Formel (2) bzw. (2a) mit einem kationischen Liganden als Gegenion gebildet werden.
Durch solche gemischten Verbindungen sind ionische Strukturen gezielt herstellbar und die Eigenschaften der erfindungsgemäßen Verbindungen justierbar.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen System mit 6-30 C-Atomen oder heteroaromatischen System mit 2-30 C-Atomen, welches noch jeweils mit den oben genannten Resten R¹ substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Cy1 und Cy2 aromatische bzw. heteroaromatische Systeme.

Bevorzugt sind Verbindungen gemäß Formel (1), enthaltend eine Teilstruktur M(L)^{t+/t-}ₙ gemäß Formel (2a), 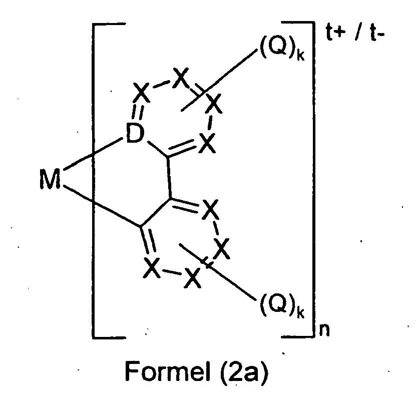 wobei M, R¹, R², L', L", n und t dieselbe Bedeutung haben, wie oben beschrieben, und für die weiteren Symbole gilt:
- D: ist gleich oder verschieden bei jedem Auftreten Stickstoff oder Phosphor;
- X: ist gleich oder verschieden bei jedem Auftreten CR¹, N oder P;
oder
(X-X) bzw. (X=X)
(also zwei benachbarte X) steht für NR¹, S oder O;
- Q: ist gleich oder verschieden bei jedem Auftreten ein positiv oder negativ geladener Substituent mit der Anzahl t an positiven oder negativen Ladungen oder für den Fall, dass der Substituent nur eine positive oder negative Ladung trägt, k-fach vorhanden ist, wobei k=t gilt;
- k: ist bei jedem Auftreten gleich oder veschieden 0, 1, 2, 3 oder 4, wobei mindestens ein Index k in Formel (2a) ungleich 0 ist;
mit der Maßgabe, dass jeder der beiden Cyclen einen Fünf- oder einen Sechsring darstellt.

In einer bevorzugten Ausführungsform der Erfindung ist Q ein positiv geladener Substituent. In einer weiteren bevorzugten Ausführungsform der Erfindung ist Q ein negativ geladener Substituent.

Geeignete Reste Q sind bevorzugt geladene heterocyclische Verbindungen auf Basis von Pyridin, Imidazol, Thiazol, Isothiazol, Oxazol, Isoxazol, Chinolin, Isochinolin, Pyridazin, Pyrimidin, Pyrazin, Purin, Phenazin oder deren Gemische, wobei die vorstehend genannten Gruppen einen oder mehrere Reste R¹ tragen können. Dabei binden diese Gruppen bevorzugt über ein Stickstoffatom an den Liganden des Komplexes.

Insofern der Rest Q für einen kationischen Substituenten steht, sind bevorzugt die Reste -N⁺(R)₃, -P⁺(R)₃, -As⁺(R)₃, -Sb⁺(R)₃, -Bi⁺(R)₃, -S⁺(R)₂, -Se⁺(R)₂, -Te⁺(R)₂ oder eine Gruppe 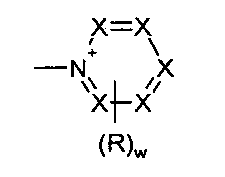 wobei w für eine ganze Zahl 1, 2, 3, 4 oder 5 steht, das Symbol X wie oben definiert ist und für R gilt:
- R: ist gleich oder verschieden bei jedem Auftreten H, Deuterium, F, CN, eine geradkettige Alkyl- oder Alkoxygruppe mit 1 bis 40 C-Atomen, eine verzweigte oder cyclische Alkyl- oder Alkoxy- gruppe mit 3 bis 40 C-Atomen, wobei bei den vorstehend genannten Alkyl- oder Alkoxygruppen jeweils eine oder mehrere nicht benachbarte CH₂-Gruppen durch -R²C=CR²-, -C≡C-, Si(R²)₂, Ge(R²)_{2,} Sn(R²)₂, -O-, -S-, -NR²-, -(C=O)-, -(C=NR²)-, -P=O(R²)- oder -CONR²- ersetzt sein können und wobei ein oder mehrere H-Atome durch F ersetzt sein können,
oder
ein aromatisches System mit 6 bis 30 C-Atomen, ein hetero- aromatisches System mit 2 bis 30 C-Atomen bzw. eine Aryloxy- oder Heteroaryloxygruppe der vorgenannten Systeme, welches jeweils durch einen oder mehrere Reste R¹ substituiert sein kann; dabei können auch zwei oder mehrere Reste R am selben Ring oder an unterschiedlichen Ringen miteinander ein weiteres aliphatisches oder aromatisches Ringsystem bilden, bevorzugt.

Besonders bevorzugte kationische Reste Q sind NR₃⁺, PR₃⁺, AsR₃⁺, SR₂⁺ und Pyridinium, ganz besonders bevorzugt sind NR₃⁺, PR₃⁺ und Pyridinium.

Insofern der Rest Q für einen anionischen Substituenten steht, sind die Reste Q bevorzugt -B⁻(R)₃, -Al⁻(R)₃, -Ga⁻(R)₃, -In⁻(R)₃, -Tl⁻(R)₃, -Si²⁻(R)₅, -Ge²⁻(R)₅, -Sn²⁻(R)₅, -Pb²⁻(R)₅, -R-O⁻, -R-S⁻, -R-COO⁻, -R-CSS⁻, -R-SO₃⁻, wobei der Rest R wie oben definiert ist, -COO⁻, -CSS⁻, -O⁻, -S⁻, -Se⁻, -Te⁻, -SO₂⁻, -SO₃⁻, -SO₄²⁻, -PO₂²⁻, -PO₃²⁻, -PO₄²⁻, [PHal₅]⁻, [AsHal₅]⁻, [SbHal₅]⁻, wobei der Rest Hal für Chlor, Brom, Iod, Fluor oder Pseudohalogenide wie SCN, CN oder OCN steht, AuCl₃⁻, PtCl₅²⁻, Fe(CN)₅^{2-/3-}, Polyelektrolyte und Ionenaustauscherharze, wie Polystyrolsulfate, bevorzugt. Besonders bevorzugte anionische Reste Q sind BR₃⁻, O⁻, S⁻, -R-COO⁻, -COO⁻ und SO₃⁻.

In einer besonderen Ausführungsform ist der Rest Q in para-Position zur Bindung an das Metall M gebunden, insbesondere am Cyclus Cy1.

In einer besonderen Ausführungsform bilden mehrere Reste R und/oder R¹ entweder am selben Cyclus oder an unterschiedlichen Cyclen ein oder mehrere aromatische oder aliphatische Ringsysteme.

Eine besonders bevorzugte Ausführungsform der vorliegenden Erfindung sind Verbindungen der Formel (1 a),

[M(L)^{t+/-}ₙ(L')ₘ(L")ₒ] [Ion]^{t-/t+}ₙ Formel (1a)

enthaltend mindestens eine Teilstruktur M(L)^{t+/t-} der Formel (2b), 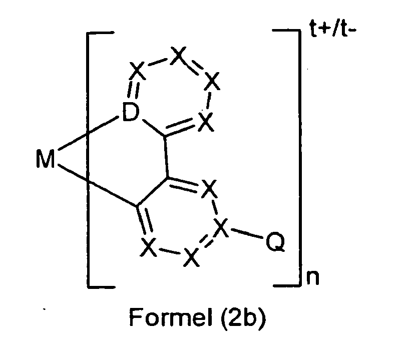 und gegebenenfalls enthaltend eine Teilstruktur M(L')ₘ der Formel (3), 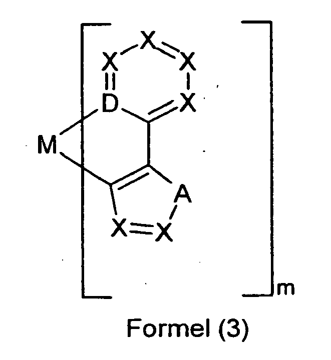 wobei M, D, X, R, R¹, R², L", Q, n, m, o und t dieselbe Bedeutung haben, wie oben beschrieben, und weiterhin gilt:
- A: ist gleich oder verschieden bei jedem Auftreten -CR¹=CR¹-, - N=CR¹- -P=CR¹-, -N=N-, -P=N-, NR¹, O oder S;
mit der Maßgabe, dass jeder der beiden Cyclen einen Fünf- oder einen Sechsring darstellt.

Erfindungsgemäße monoanionische, zweizähnige Liganden L" sind 1,3-Diketonate abgeleitet von 1,3-Diketonen, wie z. B. Acetylaceton, Benzoylaceton, 1,5-Diphenylacetylaceton, Bis(1,1,1-trifluoracetyl)methan, 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, N,N-Dimethylglycin, Alanin, N,N-Dimethylalanin, Salicyliminate abgeleitet von Salicyliminen, wie z. B. Methylsalicylimin, Ethylsalicylimin, Phenylsalicylimin, sowie Borate Stickstoff-haltiger Heterocyclen, wie z. B. Tetrakis(1-imidazolyl)borat und Tetrakis(1-pyrazolyl)borat.

Bevorzugt sind Verbindungen gemäß Formel (1) bzw. Formel (1a), bei denen für den Index n = 2 oder 3 gilt, wobei n = 3 für quadratisch-planare Komplexe nicht möglich ist. n = 2 und m = o = 0 führt zu quadratisch-planaren oder auch tetraedrischen Komplexen (mit Pt beispielsweise zu quadratisch-planaren Komplexen). n = 3 und m = o = 0 führt zu oktaedrischen Komplexen, die gegebenenfalls verzerrt sein können. Besonders bevorzugt sind Verbindungen, bei denen für den Index o = 0 gilt. Ganz besonders bevorzugt sind Verbindungen, bei denen für die Indizes m = o = 0 gilt. Dabei gilt insbesondere, dass n = 2 und m = o = 0 für quadratisch-planare Komplexe und n = 3 und m = o = 0 für oktaedrische Komplexe bevorzugt ist. Ganz besonders bevorzugt sind homoleptische Komplexe, also Komplexe mit m = o = 0, bei denen alle vorhandenen Liganden gleich und auch gleich substituiert sind. Die Bevorzugung homoleptischer Komplexe ist durch die höhere chemische und thermische Stabilität zu begründen.

Es kann bevorzugt sein, wenn zwischen den beiden Cyclen Cy1 und Cy2 eine Brücke vorliegt, die ein weiteres aromatisches oder aliphatisches Ringsystem aufspannt.

Bevorzugt sind weiterhin Verbindungen gemäß Formel (1) bzw. Formel (1a), bei denen das Symbol M für Iridium oder Platin steht, insbesondere Iridium.

Bevorzugt sind weiterhin Verbindungen gemäß Formel (1) bzw. Formel (1a), bei denen für das Symbol D = N gilt.

Bevorzugt sind weiterhin Verbindungen gemäß Formel (1) bzw. Formel (1a), bei denen für das Symbol X = CR¹ oder N gilt, insbesondere X = CR¹. Bevorzugt sind weiterhin Verbindungen gemäß Formel (1) bzw. Formel (1a), bei denen für das Symbol R¹ für aufdampfbare Systeme gilt:
- R¹: ist bei jedem Auftreten gleich oder verschieden H, F, CN, Methyl, tert- Butyl, Phenyl, CF₃ oder eine ankondensierte cyclische Alkoxygruppe mit 1 bis 4 C-Atomen.

Für Verbindungen gemäß Formel (1) bzw. Formel (1a), die aus Lösung verarbeitet werden und die daher eine gute Löslichkeit in organischen Lösemitteln aufweisen müssen, enthält bevorzugt mindestens einer der Substituenten R¹ eine Alkyl- und/oder Alkoxykette mit mindestens vier C-Atomen oder eine Alkyl-substituierte Arylgruppe oder eine ortho-Arylsubstituierte Arylgruppe, beispielsweise 2-Biphenyl. Statt dessen oder zusätzlich dazu kann auch die Gruppe Q einen oder mehrere langkettige Reste R bzw. R¹ mit mindestens vier C-Atomen tragen.

Die Synthese der Ausgangskomplexe wird bevorzugt durchgeführt, wie in WO 02/060910 und in WO 04/085449 beschrieben. Heteroleptische Komplexe können beispielsweise auch gemäß WO 05/042548 synthetisiert werden. Die Synthese der entsprechenden halogenierten Komplexe ist im Detail in WO 02/068435 beschrieben. Die erfindungsgemäßen Metallkomplexe lassen sich einfach aus den halogenierten, insbesondere bromierten Komplexen durch Umsetzung mit Phosphinen bzw. Aminen zum entsprechenden Phosphonium- bzw. Ammonium-Salz synthetisieren, beispielsweise durch Umsetzung mit einem Trialkylphosphin bzw. Trialkylamin unter Katalyse von Nickelhalogenid (z. B. NiCl₂ oder NiBr₂). Das zunächst vorhandene Anion, in diesem Fall ein Halogenid, kann in einem weiteren Schritt gegen andere Anionen ausgetauscht werden, beispielweise gegen PF₆⁻, welches zu einer nochmals besseren Löslichkeit des Komplexes führt. Durch entsprechende stöchiometrische Verhältnisse kann diese Reaktion auch selektiv an nur einem oder zwei der Liganden durchgeführt werden. Entsprechend kann bei anionischen Komplexen ein Ionenaustausch der kationischen Gegenions durchgeführt werden.

Weiterhin ist es möglich, zunächst den geladenen Liganden zu synthetisieren und in einem weiteren Schritt diesen an das Metall zu koordinieren. Die Synthese erfolgt dann mit den geladenen Liganden in Analogie zu WO 02/060910 und WO 04/085449.

Insofern das Anion lediglich eine negative Ladung trägt, kann die Anzahl der anionischen Reste dem Wert t entsprechen. Steht beispielsweise der Index t für die ganze Zahl 3, so kann das Anion entweder 3-fach vorhanden sein oder aber es liegt ein dreifach negativ geladenes Anion vor. Das gleiche gilt im umgekehrten Fall für das Kation.

Ein weiterer Gegenstand der Erfindung ist ein Verfahren zur Herstellung der erfindungsgemäßen Metallkomplexe, ausgehend von den entsprechenden halogenierten Komplexen durch Umsetzung mit substituierten Aminen, Phosphinen, Arsinen bzw. Thioethern.

Durch dieses Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Mit den hier erläuterten Synthesemethoden lassen sich unter anderem die im Folgenden dargestellten Strukturen (1) bis (54) für die Verbindungen gemäß Formel (1) herstellen. Man beachte, dass nur der geladene Iridium-Komplex abgebildet ist, das Gegenion (Anion oder Kation) kann beliebig gewählt werden.

| | | |
|---|---|---|
| 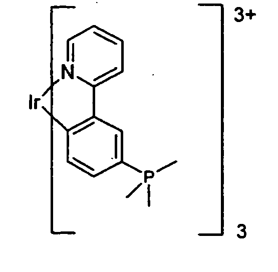 | 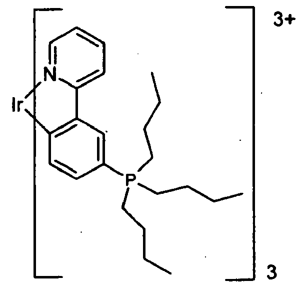 | 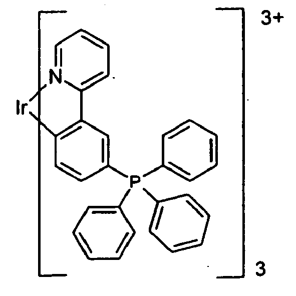 |
| (1) | (2) | (3) |
| 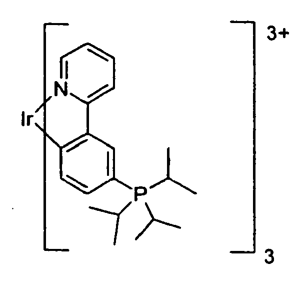 | 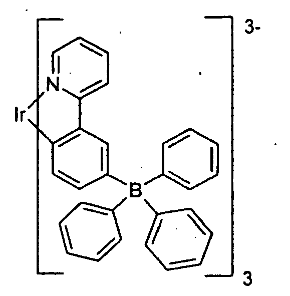 | 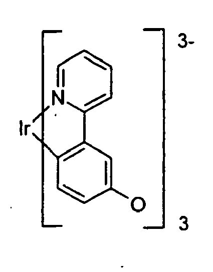 |
| (4) | (5) | (6) |
| 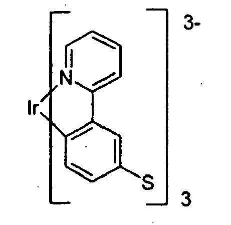 | 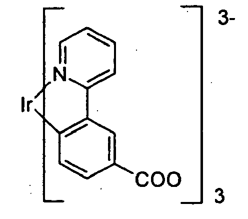 | 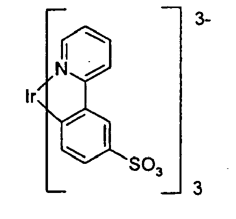 |
| (7) | (8) | (9) |
| 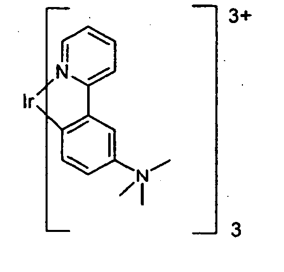 | 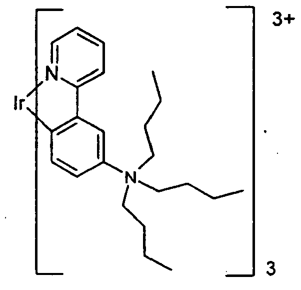 | 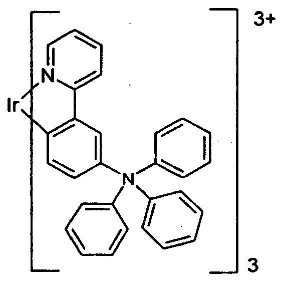 |
| (10) | (11) | (12) |
| 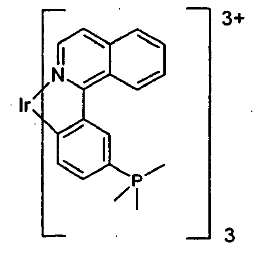 | 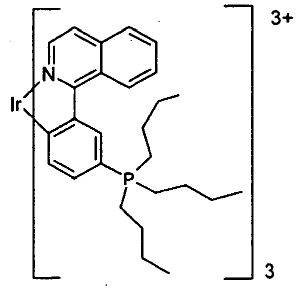 | 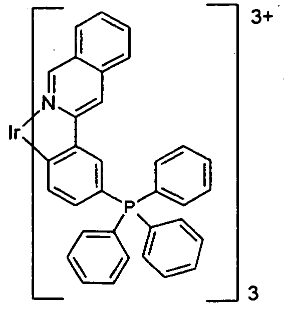 |
| (13) | (14) | (15) |
| 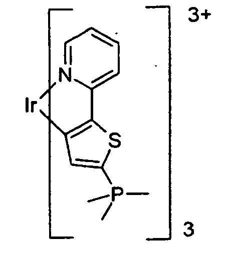 | 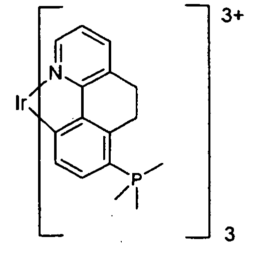 | 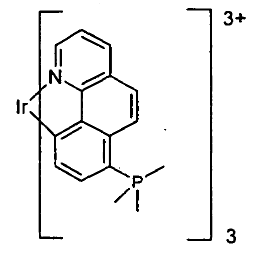 |
| (16) | (17) | (18) |
| 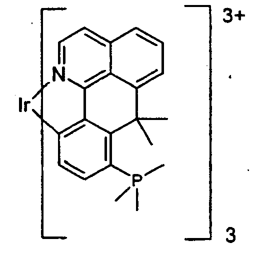 | 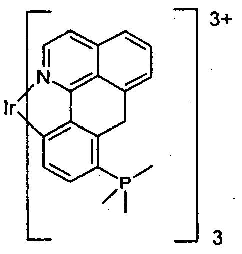 | 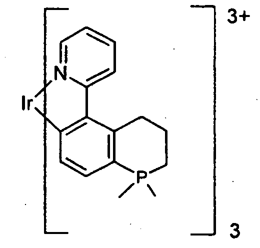 |
| (19) | (20) | (21) |
| 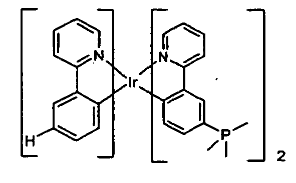 | 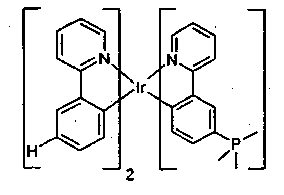 | 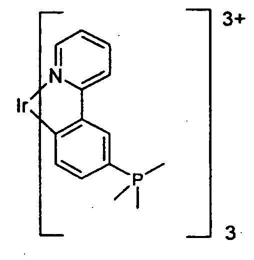 |
| (22) | (23) | (24) |
| 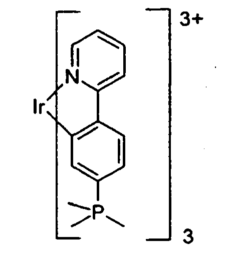 | 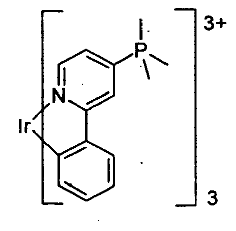 | 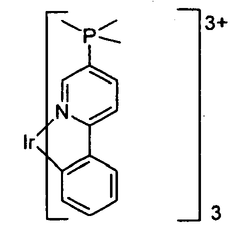 |
| (25) | (26) | (27) |
| 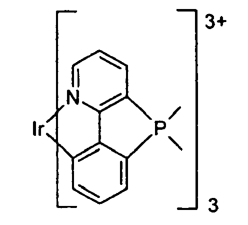 | 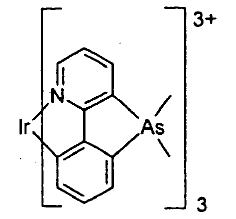 | 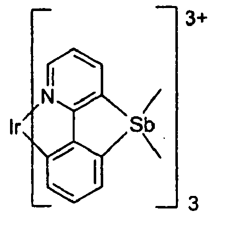 |
| (28) | (29) | (30) |
| 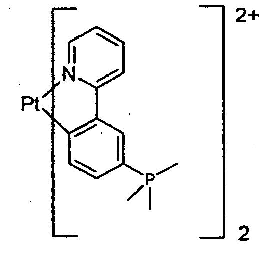 | 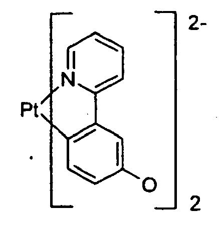 | 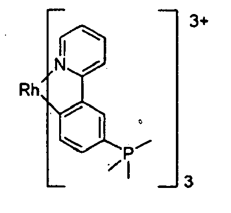 |
| (31) | (32) | (33) |
| 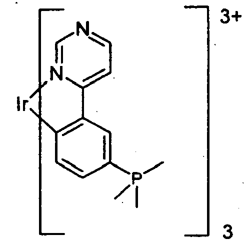 | 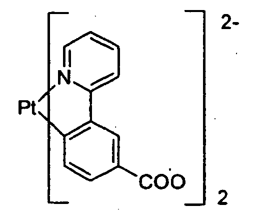 | 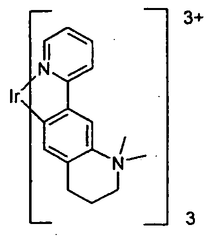 |
| (34) | (35) | (36) |
| 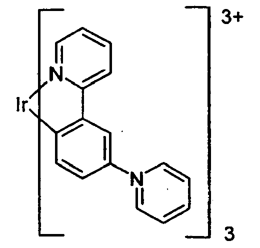 | 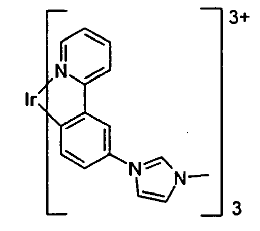 | 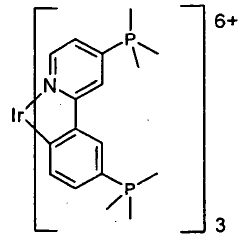 |
| (37) | (38) | (39) |
| 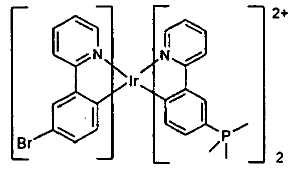 | 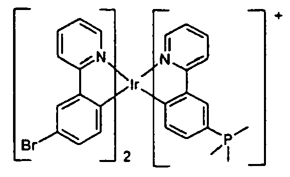 | 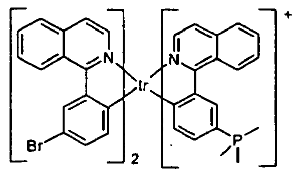 |
| (40) | (41) | (42) |
| 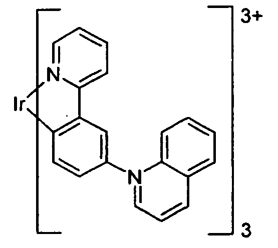 | 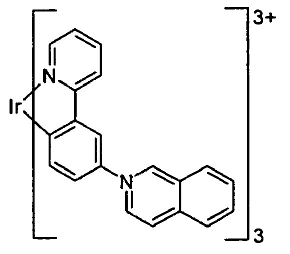 | 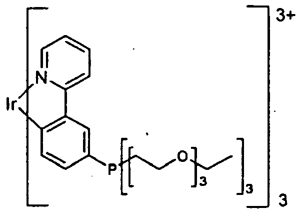 |
| (43) | (44) | (45) |
| 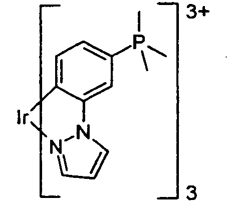 | 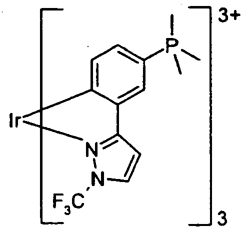 | 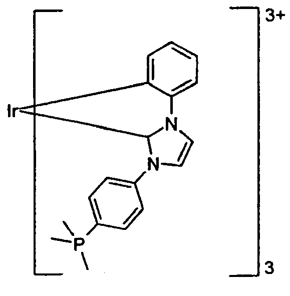 |
| (46) | (47) | (48) |
| 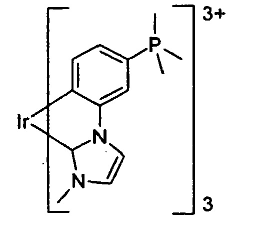 | 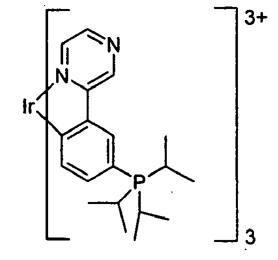 | 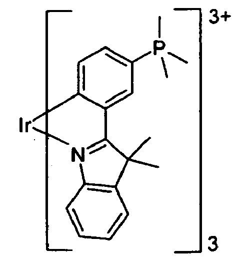 |
| (49) | (50) | (51) |
| 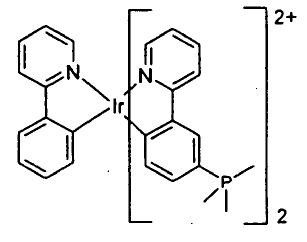 | 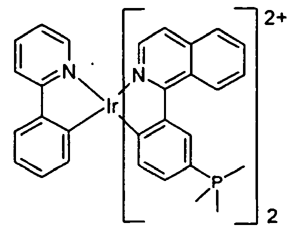 | 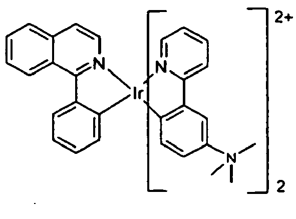 |
| (52) | (53) | (54) |

Die oben beschriebenen erfindungsgemäßen Verbindungen, z. B. Verbindungen gemäß den Strukturen 40, 41 und 42, können auch als Comonomere zur Erzeugung entsprechender konjugierter, teilkonjugierter oder nicht-konjugierter Oligomere, Polymere oder Dendrimere Verwendung finden. Die Polymerisation erfolgt dabei bevorzugt über die Bromfunktionalität. Weitere Wiederholeinheiten der Polymere sind bevorzugt ausgewählt aus der Gruppe bestehend aus Fluorenen (z. B. gemäß EP 842208 oder WO 00/22026), Spirobifluorenen (z. B. gemäß EP 707020 oder EP 894107), Dihydrophenanthrenen (z. B. gemäß WO 05/014689), Indenofluorenen (z. B. gemäß WO 04/041901 und WO 04/113412), Phenanthrenen (z. B. gemäß WO 05/104264), para-Phenylenen (z. B. gemäß WO 92/18552), Carbazolen (z. B. gemäß WO 04/070772 oder WO 04/113468), Ketonen (z. B. gemäß WO 05/040302), Silanen (z. B. gemäß WO 05/111113), Triarylaminen oder Thiophenen (z. B. gemäß EP 1028136) oder auch mehrere verschiedene dieser Einheiten. Dabei können die erfindungsgemäßen Metallkomplexe entweder in die Seitenkette oder in die Hauptkette des Polymers eingebaut werden oder können auch Verzweigungspunkte der Polymerketten (z. B. gemäß WO 06/003000) darstellen.

Weiterer Gegenstand der Erfindung sind somit konjugierte, teilkonjugierte oder nicht-konjugierte Oligomere, Polymere oder Dendrimeren, enthaltend eine oder mehrere der Verbindungen gemäß Formel (1) bzw. Formel (1a), wobei mindestens einer der oben definierten Reste R bzw. R¹, bevorzugt R¹, eine Bindung zum Polymer oder Dendrimer darstellt. Für Einheiten gemäß Formel (1) bzw. Formel (1a) gelten in Polymeren und Dendrimeren dieselben Bevorzugungen, wie oben bereits beschrieben.

Durch die gute Löslichkeit lassen sich die erfindungsgemäßen Komplexe gut einpolymerisieren, während Komplexe nach dem Stand der Technik häufig wegen der schlechten Löslichkeit bei der Polymerisation zu Problemen führt.

Die oben genannten Oligomere, Polymere, Copolymere und Dendrimere zeichnen sich durch ihre gute Löslichkeit in organischen Lösemitteln und hohe Effizienz und Stabilität in organischen elektrolumineszierenden Vorrichtungen aus.

Weiterhin können die erfindungsgemäßen Verbindungen gemäß Formel (1), insbesondere solche, die durch Halogene funktionalisiert sind, auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß Suzuki oder mit Aminen gemäß Hartwig-Buchwald zu nennen.

Weiterer Gegenstand der Erfindung sind Lösungen enthaltend die erfindungsgemäßen Verbindungen bzw. die erfindungsgemäßen Oligomere, Polymere oder Dendrimere. Bevorzugte Lösemittel sind hier dipolar-aprotische oder dipolar-protische Lösemittel, insbesondere DMF, DMSO, NMP, Alkohole, Glycole oder Wasser.

Die erfindungsgemäßen Verbindungen, Oligomere, Polymere, Dendrimere oder erweiterten Verbindungen gemäß Formel (1) finden Verwendung als aktive Komponenten in organischen elektronischen Bauteilen, wie z. B. organischen Leuchtdioden (OLEDs, PLEDs), lichtemittierenden elektrochemischen Zellen (LECs), organischen integrierten Schaltungen (O-ICs), organischen Feld-Effekt-Transistoren (O-FETs), organischen Dünnfilmtransistoren (O-TFTs), organischen Solarzellen (O-SCs), organischen Feld-Quench-Devices (O-FQDs) oder organischen Laserdioden (O-Laser).

Gegenstand der vorliegenden Erfindung ist also weiterhin die Verwendung der erfindungsgemäßen Verbindungen gemäß Formel (1), der erfindungsgemäßen Oligomere, Polymere und Dendrimere und entsprechender erweiterter Verbindungen gemäß Formel (1) als aktive Komponente in organischen elektronischen Bauteilen, insbesondere als emittierende Verbindung.

Weiterer Gegenstand der Erfindung sind elektronische Bauteile, ausgewählt aus der Gruppe der organischen und polymeren Leuchtdioden (OLEDs, PLEDs), lichtemittierenden elektrochemischen Zellen (LECs) (z. B. E. S. Handy et al., J. Am. Chem. Soc. 1999, 121, 3525-3528; J. Slinker et al., Chem. Commun. 2003, 2392-2399), organischen Feld-Effekt-Transistoren (O-FETs), organischen Dünnfilmtransistoren (O-TFTs), organischen integrierten Schaltungen (O-ICs), organischen Solarzellen (O-SCs), organischen Feld-Quench-Devices (O-FQDs), Sauerstoffsensoren, vor allem Sauerstoffsensoren, die in wässriger Lösung arbeiten, und organischen Laserdioden (O-Laser), insbesondere organische und polymere Leuchtdioden, enthaltend eine oder mehrere erfindungsgemäße Verbindungen gemäß Formel (1), erfindungsgemäße Oligomere, Polymere und Dendrimere und entsprechende erweiterte Verbindungen gemäß Formel (1), insbesondere als emittierende Verbindung.

Die erfindungsgemäßen Verbindungen weisen die folgenden Vorteile gegenüber Verbindungen gemäß dem Stand der Technik auf:
1. Die erfindungsgemäßen Verbindungen lassen sich leichter synthetisieren als geladene Metallkomplexe gemäß dem Stand der Technik. Dies stellt einen deutlichen technischen Vorteil dar.
2. Die erfindungsgemäßen Verbindungen zeichnen sich durch eine gute Löslichkeit in organischen Lösungsmitteln aus, insbesondere in dipolaren und dipolar-protischen Lösemitteln, was ihre Reinigung durch gängige Verfahren wie Umkristallisation oder Chromatographie erheblich erleichtert. Damit sind die Verbindungen auch gut aus Lösung durch Beschichtungs- oder Drucktechniken verarbeitbar. Auch bei der Synthese ist diese Eigenschaft von Vorteil, da so die Reinigung der Substanzen, beispielsweise durch Umkristallisation, erheblich erleichtert wird. Ein weiterer Vorteil der hohen Löslichkeit ist, dass sich entsprechend funktionalisierte Komplexe dadurch leichter einpolymerisieren lassen als Komplexe gemäß dem Stand der Technik.
3. Die erfindungsgemäßen Metallkomplexe sind insbesondere auch in polar-protischen und polar-aprotischen Lösemitteln löslich. Dagegen sind die meisten anderen funktionellen Materialien, die in OLEDs verwendet werden, in unpolaren Lösemitteln löslich. Durch die unterschiedliche Löslichkeit der Materialien lassen sich so einfach Mehrschicht-Devices aus Lösung aufbauen, die beispielsweise insgesamt zu weißer Emission führen.
4. Bei Einsatz in OLEDs zeigen die erfindungsgemäßen Verbindungen eine geringere Einsatzspannung als Verbindungen gemäß dem Stand der Technik. Sie sind daher besser für den Einsatz in OLEDs und organischen lichtemittierenden Zellen geeignet als die Komplexe gemäß dem Stand der Technik.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Verbindungen herstellen bzw. diese in organischen elektronischen Vorrichtungen verwenden.

### Beispiele:

Die nachfolgenden Synthesen werden, sofern nicht anders angegeben, unter einer Schutzgasatmosphäre durchgeführt. Die Edukte können von den Firmen ALDRICH bzw. ABCR (Tri-n-butylphosphan, Nickel(II)chlorid, Anorganika, Lösemittel) bezogen werden. *fac*-Tris[2-(2-pyridinyl-κN)(5-bromphenyl)-κC]-iridium(III) wird nach WO 02/068435 dargestellt.

### Beispiel 1: fac-Tris[2-(2-pyridinyl-κN)-5(tri-n-butylphosphonium)phenyl)-κC]-iridium(III)-tribromid

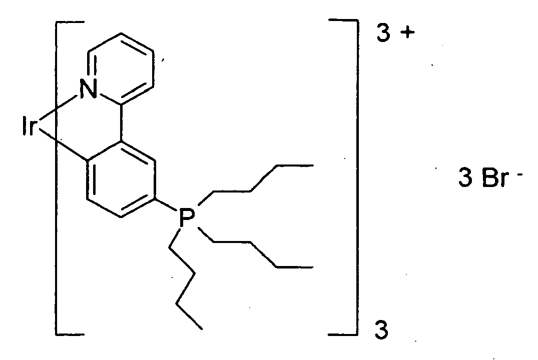

Eine entgaste Suspension von 3.00 g (3.37 mmol) *fac*-Tris[2-(2-pyridinyl-κN)(5-bromphenyl)-κC]-iridium(III) und 6.5 mg (0.05 mmol) NiCl₂ in 70 ml 1-Methyl-2-pyrrolidon (NMP) wird mit 25.0 ml (100 mmol) Tri-n-butylphosphan versetzt und 16 h auf 150 °C erhitzt. Nach Erkalten wird die Mischung mit 400 ml Chloroform versetzt. Die organische Phase wird fünfmal mit 100 ml Wasser gewaschen, abgetrennt, über Mg₂SO₄ getrocknet und im Vakuum vom Lösemittel befreit. Anschließend wird das Produkt dreimal aus wenig Essigsäureethylester umkristallisiert. Die Ausbeute - bei einer Reinheit von 99.5 % nach NMR - beträgt 3.20 g (2.13 mmol), entsprechend 63.2 % d. Th.

### Beispiel 2: Löslichkeit von fac-Tris[2-(2-pyridinyl-κN)-5(tri-n-butylphosphonium)phenyl)-κC]-iridium(III)-tribromid

Untenstehende Tabelle gibt die Löslichkeit von *fac*-Tris[2-(2-pyridinyl-KN)-5(tri-n-butylphosphonium)phenyl)-κC]-iridium(III)-tribromid in verschiedenen Lösungsmitteln bei T = 25 °C an. Man findet ausgezeichnete Löslichkeit des Komplexes in vielen gängigen organischen Lösemitteln, selbst in polar-protischen Lösemitteln wie Ethanol und Ethanol-Wasser-Gemischen. Als Vergleich gemäß dem Stand der Technik ist die Löslichkeit von *fac*-Tris[2-(2-pyridinyl-κN)-phenyl-κC]-iridium(III) (IrPPy) angegeben.

| **Lösemittel** | **Löslichkeit [g/l]** | **Löslichkeit [g/l]** |
|---|---|---|
| | Komplex aus Beispiel 1 | IrPPy |
| Wasser | 11.5 | 0 |
| Wasser / Ethanol (1:1, v,v) | 43.0 | 0 |
| Ethanol | 134.0 | < 0.1 |
| Aceton | unbeschränkt | <1.0 |
| Dichlormethan | unbeschränkt | < 10.0 |
| Chloroform | unbeschränkt | < 10.0 |
| Toluol | unbeschränkt | < 2.0 |
| DMF | unbeschränkt | < 2.0 |
| NMP | unbeschränkt | < 2.0 |
| DMSO | unbeschränkt | < 2.0 |
| Hexan | > 1.0 | < 1.0 |

### Beispiel 3:

Analog zu Beispiel 1 werden durch Umsetzung von *fac*-Tris[2-(2-pyridinyl-κN)(5-bromphenyl)-κC]-iridium(III) bzw. den entsprechenden analogen Iridiumkomplexen mit den entsprechenden Phosphinen folgende Verbindungen dargestellt.

| Beispiel | Phosphin | Produkt |
|---|---|---|
| 4 | 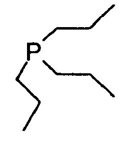 | 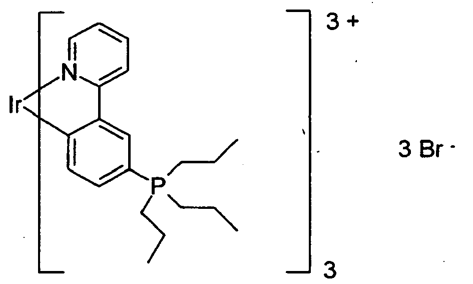 |
| 5 | 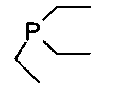 | 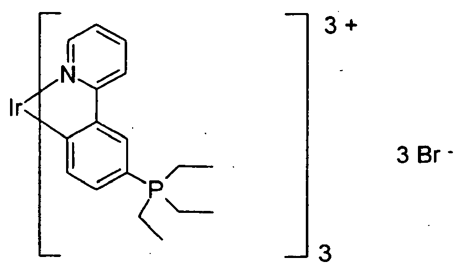 |
| 6 | 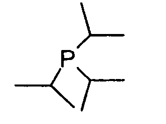 | 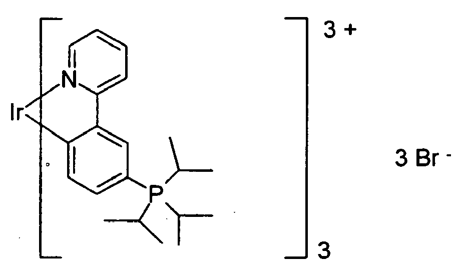 |
| 7 | 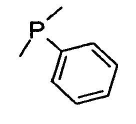 | 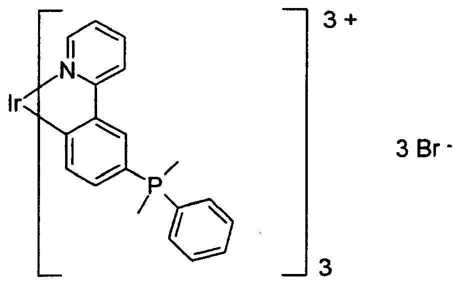 |
| 8 | 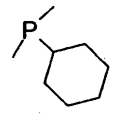 | 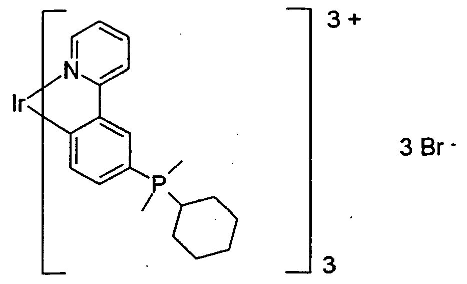 |
| 9 | 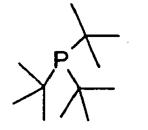 | 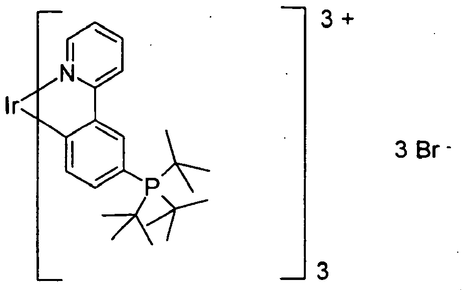 |
| 10 | 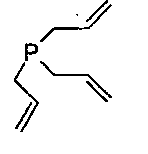 | 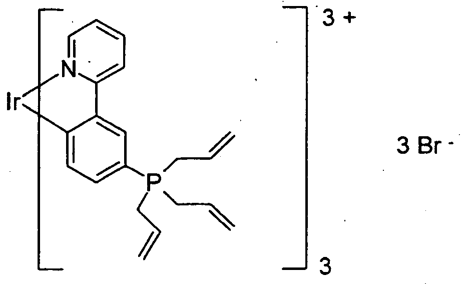 |
| 11 | 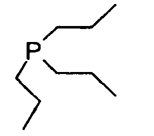 | 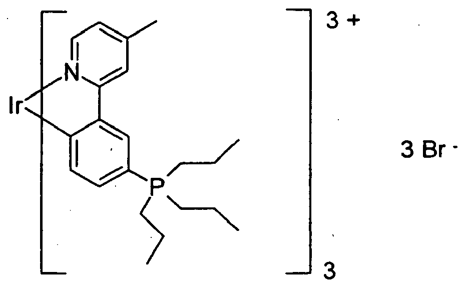 |
| 12 | 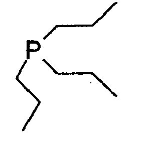 | 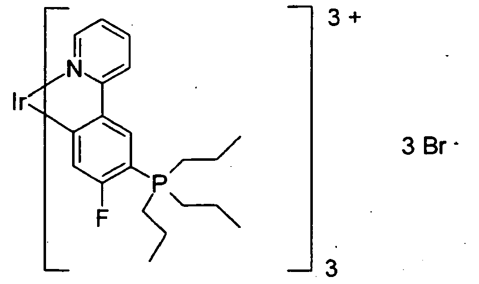 |
| 13 | 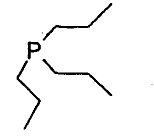 | 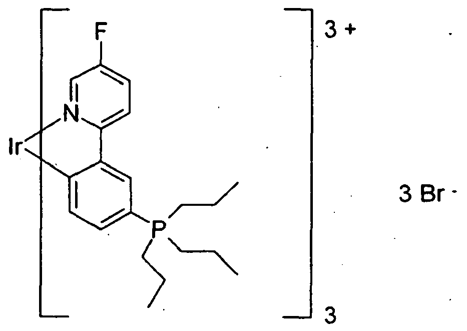 |
| 14 | 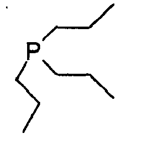 | 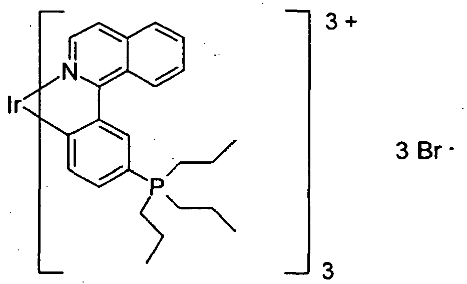 |
| 15 | 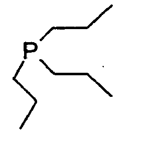 | 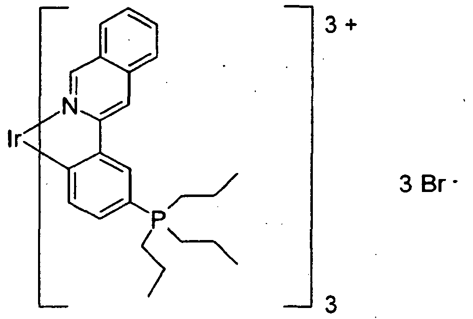 |

### Beispiel 16: fac-Tris[2-(2-pyridinyl-κN)-5(trimethylamino)phenyl)-κC]-iridium(III)-tribromid

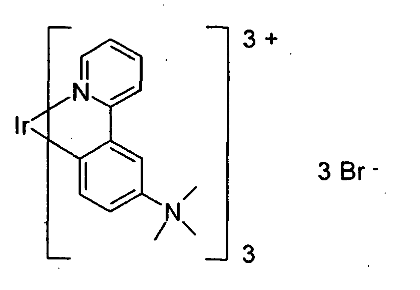

Eine entgaste Suspension von 892 mg (1 mmol) *fac*-Tris[2-(2-pyridinyl-κN)(5-bromphenyl)-κC]-iridium(III) in 30 ml Dioxan wird mit 520 mg (10 mmol) Lithiumdimethylamid versetzt und im Bombenrohr 16 h auf 140 °C erhitzt. Nach Erkalten wird mit 1.3 ml (20 mmol) Methyliodid versetzt und erneut im Bombenrohr 16 h auf 100 °C erhitzt. Nach Erkalten wird die Mischung vorsichtig mit einem Gemisch aus 1 ml konz. Ammoniakwasser und 50 ml Dioxan versetzt, 3 h bei Raumtemperatur gerührt und im Vakuum zur Trockene eingeengt. Anschließend wird das Produkt dreimal aus wenig Acetonitril umkristallisiert. Die Ausbeute - bei einer Reinheit von 99.7 % nach NMR - beträgt 880 mg (0.8 mmol), entsprechend 82.3 % d. Th.

### Beispiel 17:

Analog zu Beispiel 16 werden durch Umsetzung von *fac*-Tris[2-(2-pyridinyl-κN)(5-bromphenyl)-κC]-iridium(III) bzw. den entsprechenden analogen Iridiumkomplexen mit den entsprechenden sekundären Lithiumamiden und anschließende Alkylierung mit den entsprechenden Alkyliodiden folgende Verbindungen dargestellt.

| Beispiel | Sec. Amin | Alkyliodid | Produkt |
|---|---|---|---|
| 18 | 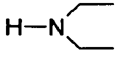 | CH₃I | 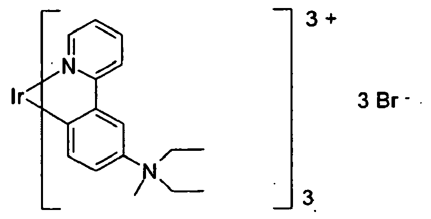 |
| 19 | 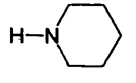 | CH₃I | 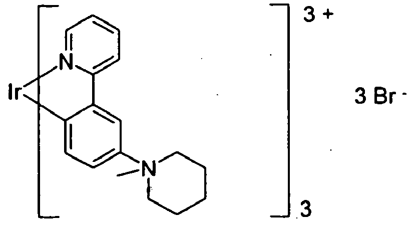 |
| 20 | 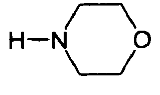 | CH₃I | 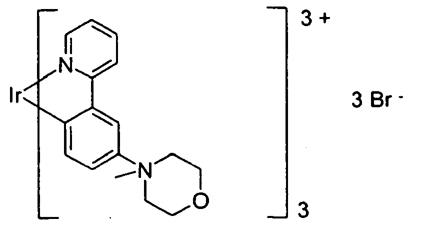 |
| 21 | 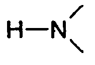 | 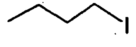 | 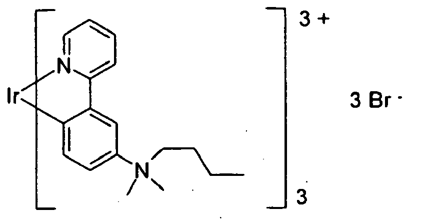 |
| 22 | 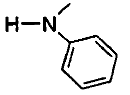 | CH₃I | 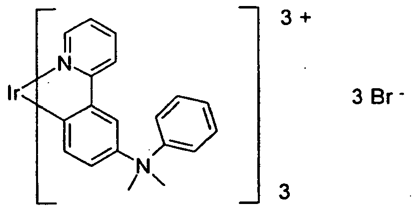 |
| 23 | 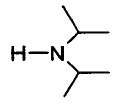 | CH₃I | 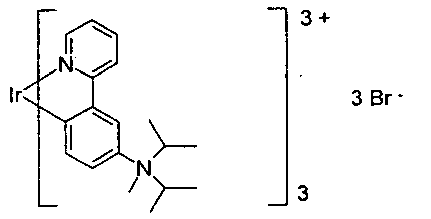 |

### Beispiel 24: Tris(tetramethylammonium)-fac-tris[2-(2-pyridinyl-κN)-5(phenoxy)-κC]-iridium(III)

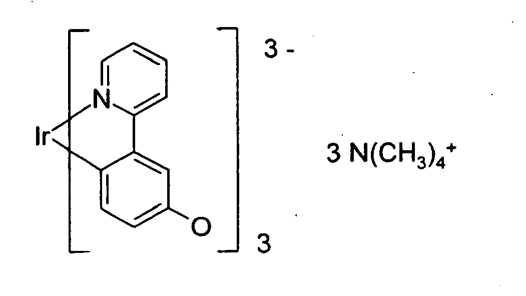

Eine entgaste Suspension von 2.67 g (3 mmol) fac-Tris[2-(2-pyridinyl-κN)(5-bromphenyl)-κC]-iridium(III) und 6.5 mg (0.05 mmol) NiCl₂ in 50 ml 1-Methyl-2-pyrrolidon (NMP) wird mit 1.62 g (30 mmol) Natriummethylat versetzt und 16 h auf 150 °C erhitzt. Nach Erkalten wird die Mischung mit 13.4 g (100 mmol) wasserfreiem Lithiumiodid versetzt und 24 h auf 180 °C erhitzt. Nach Erkalten wird die Reaktionsmischung auf 200 ml Wasser gegeben. Die Mischung wird mit konz. Salzsäure auf pH = 1 eingestellt und dreimal mit je 100 ml Dichlormethan extrahiert. Die vereinigten organischen Phasen werden dreimal mit 0.01 N Salzsäure gewaschen, über Magnesiumsulfat getrocknet und zur Trockene eingeengt. Der Rückstand wird in 20 ml Methanol suspendiert, mit 1.8 g Tetramethylammoniumhydroxid Pentahydrat versetzt und 16 h gerührt. Die ausgefallenen Kristalle werden abgesaugt, einmal mit 5 ml eiskaltem Methanol und dreimal mit 10 ml Diethylether gewaschen. Die Ausbeute, bei einer Reinheit von 99.0 % nach NMR, beträgt 1.49 g (1.6 mmol), entsprechend 53.8 % d. Th.

### Beispiel 25: Tri-natrium-fac-tris[2-(2-pyridinyl-κN)-5(phenylsulfonium)-κC]-iridium(III)

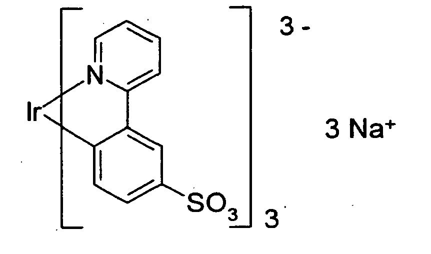

Eine Lösung von 655 mg (1 mmol) fac-Tris[2-(2-pyridinyl-κN)-5(phenyl)-κC]iridium(III) in 200 ml Dichlormethan wird mit 1.91 g (12 mmol) Schwefeltrioxid-Pyridin-Komplex versetzt und 16 h unter Lichtausschluss gerührt. Anschließend engt man die Mischung im Vakuum auf ein Volumen von 5 ml ein, gibt 648 mg (12 mmol) Natriummethylat zu, rührt weitere 3 h nach, gibt 25 ml Diethylether zu, lässt 16 h bei Raumtemperatur stehen, saugt von den ausgefallenen Kristallen ab, wäscht diese dreimal mit je 10 ml Diethylether, kristallisiert erneut aus Dichlormethan / Diethylether (1:5, v:v) um, saugt ab, wäscht die Kristalle dreimal mit je 10 ml Diethylether und trocknet im Vakuum. Die Ausbeute, bei einer Reinheit von 99.0 % nach NMR, beträgt 431 mg (0.5 mmol), entsprechend 44.8 % d. Th.

### Beispiel 26: fac-Tris[2-(2-pyridinyl-κN)-5-(trimethylamino)phenyl)-κC]-iridium(III) mit fac-Tris[2-(2-pyridinyl-κN)-5(phenoxy)-κC]-iridium(III)

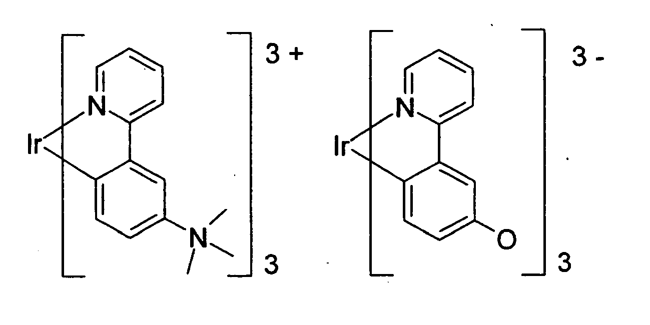

Ein Gemisch aus 1069 mg (1 mmol) fac-Tris[2-(2-pyridinyl-κN)-5-(trimethyl-amino)phenyl)-κC]-iridium(III)-tribromid und 922 mg (1 mmol) Tri-natrium-fac-tris[2-(2-pyridinyl-κN)-5(phenoxy)-κC]-iridium(III) in 100 ml Dichlormethan wird 5 h bei Raumtemperatur gerührt. Die Suspension wird über eine Säule mit in Dichlormethan aufgeschlämmtem Kieselgel (30 g) filtriert, das Kieslgel wird mit 50 ml Dichlormethan nachgewaschen, die vereinigten Dichlormethan-Phasen werden eingeengt und der Rückstand wird aus wenig Dichlormethan / Diethylether (1:5, w) umkristallisiert. Die Ausbeute, bei einer Reinheit von 99.5 % nach NMR, beträgt 1346 mg (0.9 mmol), entsprechend 88.0 % d. Th.

### Beispiel 27: Herstellung und Charakterisierung von OLEDs

Die erfindungsgemäßen Verbindungen werden in Blends für einen Einsatz in OLEDs untersucht. Diese OLEDs sind jeweils Zweischichtsysteme, d. h. Substrat//ITO//PEDOTI/Polymer//Kathode. PEDOT ist ein Polythiophen-Derivat (Baytron P von H. C. Stark, Goslar). Als Kathode wird in allen Fällen Ba/Ag (beide von Aldrich) verwendet. Wie OLEDs dargestellt werden können, ist in WO 04/037887 und der darin zitierten Literatur ausführlich beschrieben.

Die Herstellung der Blends erfolgt durch Lösen der Blendbestandteile im gewünschten Verhältnis und in der gewünschten Konzentration in einem geeigneten Lösemittel. Als Lösemittel wird hier beispielhaft Toluol verwendet. Dabei wird der Lösevorgang in einer inerten Atmosphäre bei 60 °C durchgeführt. Die Lösung wird ohne Isolierung des Blends (nochmaliges Ausfällen der Feststoffanteile) direkt verarbeitet. Alternativ können die Komponenten auch einzeln gelöst und dann über die entsprechenden Volumina zu einer gemeinsamen Lösung vereinigt werden.

Einige Device-Eigenschaften (Farbe, Effizienz, Betriebsspannung) der erfindungsgemäßen Blends **BLEND1** bis **BLEND4** sind in Tabelle 1 aufgeführt.

### BLEND1:

Toluollösung enthaltend:
- 5.0 Gew.-% Poly(N-vinylcarbazol), Mn = 25.000-50.000 von der Fa. Aldrich
- 0.5 Gew.-% Emitter nach Beispiel 1

### BLEND2:

Toluollösung enthaltend:
- 5.0 Gew.-% Poly-(N-vinylcarbazol), Mn = 25.000-50.000 von der Fa. Aldrich
- 0.5 Gew.-% Emitter nach Beispiel 14

### BLEND3:

Toluollösung enthaltend:
- 5.0 Gew.-% Polymer P1 nach WO 04/070772
- 0.5 Gew.-% Emitter nach Beispiel 16

### BLEND4:

Toluollösung enthaltend:
- 5.0 Gew.-% Polymer P1 nach WO 04/070772
- 0.5 Gew.-% Emitter nach Beispiel 26

| BLEND | Schichtdicke | Maximale Effizienz | Spannung bei 500 cd/m² | Farbe (CIE) |
|---|---|---|---|---|
| | [nm] | [cd/A] | [V] | x; y |
| 1 | 80 | 23.4 | 6.3 | 0.33; 0.53 |
| 2 | 80 | 11.8 | 6.5 | 0.66; 0.34 |
| 3 | 80 | 26.5 | 6.4 | 0.31; 0.51 |
| 4 | 80 | 17.9 | 6.7 | 0.46; 0.37 |

## Patentansprüche

1. Ionische Verbindungen gemäß Formel (1)
[M(L)^{t+/t-}ₙ(L')ₘ(L")ₒ] [Ion]^{t-/t+}ₙ Formel (1)
enthaltend eine Teilstruktur M(L)^{t+/t-}ₙ gemäß Formel (2) als Kation oder Anion, 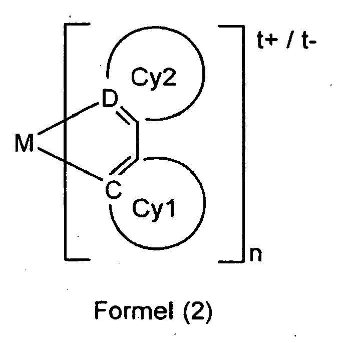 wobei für die verwendeten Symbole und Indizes gilt:
M ist bei jedem Auftreten ein Element der ersten bis neunten Nebengruppe des Periodensystems der Elemente, vorzugs- weise Iridium, Rhodium, Platin, Palladium, Gold, Wolfram, Rhenium, Ruthenium oder Osmium;
D ist gleich oder verschieden bei jedem Auftreten ein sp²-hybridisiertes Heteroatom mit einem nicht-bindenden Elektronenpaar, das an M koordiniert;
C ist bei jedem Auftreten ein sp²-hybridisiertes Kohlen- stoffatom, das an M bindet;
Cy1 ist gleich oder verschieden bei jedem Auftreten ein gege- benenfalls durch R¹ und/oder Q substituierter Homo- oder Heterocyclus, der über ein sp²-hybridisiertes Kohlenstoffatom an M bindet; dabei kann Cy1 sowohl ein Monocyclus wie auch ein Oligocyclus sein;
Cy2 ist gleich oder verschieden bei jedem Auftreten ein gege- benenfalls durch R¹ und/oder Q substituierter Heterocyclus, der über das Atom D an M koordiniert; dabei kann Cy2 sowohl ein Monocyclus wie auch ein Oligocyclus sein;
Q ist gleich oder verschieden bei jedem Auftreten ein positiv oder negativ geladener Substituent mit der Anzahl t an positiven oder negativen Ladungen;
R¹ ist gleich oder verschieden bei jedem Auftreten H, Deuterium, F, Cl, Br, I, OH, NO₂, CN, N(R²)₂, B(OH)₂, B(OR²)₂, eine geradkettige Alkyl- oder Alkoxygruppe mit 1 bis 40 C-Atomen, eine verzweigte oder cyclische Alkyl- oder Alkoxygruppe mit 3 bis 40 C-Atomen, wobei bei den vorstehend genannten Alkyl- oder Alkoxygruppen jeweils eine oder mehrere nicht benach- barte CH₂-Gruppen durch -R²C=CR²-, -C≡C-, Si(R²)₂, Ge(R²)₂, Sn(R²)₂, -O-, -S-, -NR²-, -(C=O)-, -(C=NR¹)-, -P=O(R²)-, -COOR²- oder -CONR²- ersetzt sein können und wobei ein oder mehrere H-Atome durch F ersetzt sein können,
oder
ein aromatisches System mit 6 bis 30 C-Atomen, ein hetero- aromatisches System mit 2 bis 30 C-Atomen bzw. eine Aryloxy- oder Heteroaryloxygruppe der vorgenannten Systeme, welches jeweils durch einen oder mehrere nicht- aromatische Reste R¹ substituiert sein kann, wobei mehrere Substituenten R¹, sowohl am selben Ring als auch an unters- chiedlichen Ringen zusammen wiederum ein weiteres mono- oder polycyclisches, aliphatisches oder aromatisches Ringsystem aufspannen können;
R² ist gleich oder verschieden bei jedem Auftreten H oder ein aliphatischer Kohlenwasserstoffrest mit 1 bis 20 C-Atomen oder aromatischer Kohlenwasserstoffrest mit 6 bis 20 C-Atomen oder ein heteroaromatischer Kohlenwasser- stoffrest mit 2 bis 30 C-Atomen;
n ist 1, 2 oder 3;
t ist 1, 2 oder 3, vorzugsweise 1 oder 2, insbesondere 1, wobei der Ligand selber die Ladung trägt;
dabei sind.die Liganden L' und L" in Formel (1) monoanionische, zweizähnig chelatisierende Liganden; m und o sind gleich oder verschieden bei jedem Auftreten 0, 1 oder 2;
**dadurch gekennzeichnet, dass** an der Struktur der Formel (2) mindestens eine Gruppe Q vorhanden ist;
und ein Ion, welches als Gegenion zum Komplexion [M(L)^{t+/t-}ₙ(L')ₘ(L")ₒ] wirkt.

2. Verbindungen gemäß Anspruch 1, **dadurch gekennzeichnet, dass** Cy1 und Cy2 aromatische bzw. heteroaromatische Systeme sind.

3. Verbindungen gemäß Anspruch 1, **dadurch gekennzeichnet, dass** Cy2 ein Carben ist, welches über ein Kohlenstoffatom statt über ein Heteroatom D an das Metall M koordiniert.

4. Verbindungen gemäß Anspruch 1 oder 2, **dadurch gekennzeichnet, dass** sie mindestens eine Teilstruktur M(L)^{t+/t-}ₙ gemäß Formel (2a) enthalten, 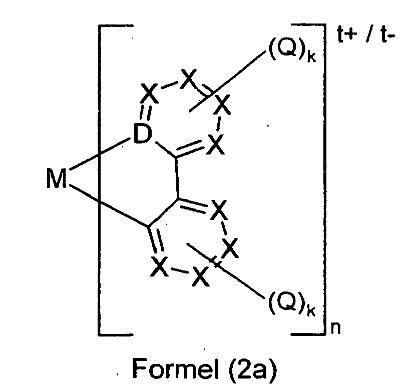 wobei M, R¹, R², L', L", n und t dieselbe Bedeutung haben, wie unter Anspruch 1 beschrieben, und für die weiteren Symbole gilt:
D ist gleich oder verschieden bei jedem Auftreten Stickstoff oder Phosphor;
X ist gleich oder verschieden bei jedem Auftreten CR¹, N oder P; oder
(X-X) bzw. (X=X) (also zwei benachbarte X) steht für NR¹, S oder O;
Q ist gleich oder verschieden bei jedem Auftreten ein positiv oder negativ geladener Substituent mit der Anzahl t an positiven oder negativen Ladungen oder für den Fall, dass der Substituent nur eine positive oder negative Ladung trägt, k-fach vorhanden ist, wobei k=t gilt;
k ist bei jedem Auftreten gleich oder veschieden 0, 1, 2, 3 oder 4, wobei mindestens ein Index k in Formel (2a) ungleich 0 ist;
mit der Maßgabe, dass jeder der beiden Cyclen einen Fünf- oder einen Sechsring darstellt.

5. Verbindungen gemäß mindestens einem der vorhergehenden Ansprüche, **dadurch gekennzeichnet, dass** es sich um eine Verbindungen der Formel (1a) handelt,
[M(L)^{t+/-}ₙ(L')ₘ(L")ₒ] [Ion]^{t-/t+}ₙ Formel (1a)
enthaltend mindestens eine Teilstruktur M(L)^{t+/t-}ₙ der Formel (2b), 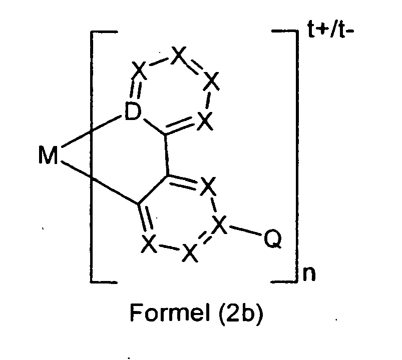 und gegebenenfalls enthaltend eine Teilstruktur M(L')ₘ der Formel (3), 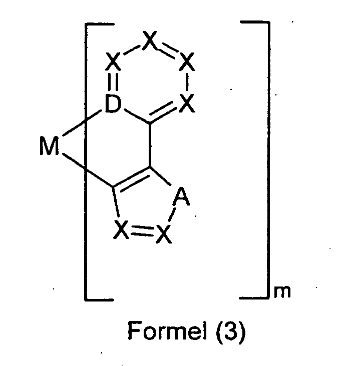 wobei M, D, X, R¹, R², L", Q, n, m, o und t dieselbe Bedeutung haben, wie unter Anspruch 1 und 4 beschrieben, und weiterhin gilt:
A ist gleich oder verschieden bei jedem Auftreten -CR¹=CR¹-, -N=CR¹-, -P=CR¹-, -N=N-, -P=N-, NR¹, O oder S;
mit der Maßgabe, dass jeder der beiden Cyclen einen Fünf- oder einen Sechsring darstellt.

6. Verbindungen gemäß mindestens einem der vorhergehenden Ansprüche, **dadurch gekennzeichnet, dass** die ionischen Verbindungen der Formel (1) bzw. (1a) als gemischte Salze vorliegen.

7. Verbindungen gemäß Anspruch 6, **dadurch gekennzeichnet, dass** die Verbindung der Formel (1) eine Teilstruktur M(L)^{t+}ₙ gemäß Formel (2) bzw. (2a) mit einem kationischen Liganden und das Anion aus einer Teilstruktur M(L)^{t-}ₙ gemäß Formel (2) bzw. (2a) mit einem anionischen Liganden als Gegenion gebildet wird.

8. Verbindungen gemäß Anspruch 4 oder 5, **dadurch gekennzeichnet, dass** Q für eine geladene heterocyclische Gruppe auf Basis von Pyridin, Imidazol, Thiazol, Isothiazol, Oxazol, Isoxazol, Chinolin, Isochinolin, Pyridazin, Pyrimidin, Pyrazin, Purin, Phenazin oder deren Gemische, wobei die vorstehend genannten Gruppen einen oder mehrere Reste R¹, wie in Anspruch 1 definiert, tragen können, steht.

9. Verbindungen gemäß mindestens einem der vorhergehenden Ansprüche, **dadurch gekennzeichnet, dass** Q für einen kationischen Substituenten steht.

10. Verbindungen gemäß Anspruch 9, **dadurch gekennzeichnet, dass** Q für einen oder mehrere Reste -N⁺(R)₃, -P⁺(R)₃, -As⁺(R)₃, -Sb⁺(R)₃, -Bi⁺(R)₃, -S⁺(R)₂, -Se⁺(R)₂, -Te⁺(R)₂ oder eine Gruppe 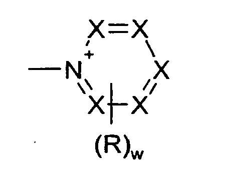 steht, wobei w eine ganze Zahl 1, 2, 3, 4 oder 5, das Symbol X gemäß Anspruch 4 definiert ist und für R gilt:
R ist gleich oder verschieden bei jedem Auftreten H, Deuterium, F, CN, eine geradkettige Alkyl- oder Alkoxygruppe mit 1 bis 40 C-Atomen, eine verzweigte oder cyclische Alkyl- oder Alkoxygruppe mit 3 bis 40 C-Atomen, wobei bei den vor- stehend genannten Alkyl- oder Alkoxygruppen jeweils eine oder mehrere nicht benachbarte CH₂-Gruppen durch -R²C=CR²-, -C≡C-, Si(R²)_{2,} Ge(R²)₂, Sn(R²)₂, -O-, -S-, -NR²-, -(C=O)-, -(C=NR²)-, -P=O(R²)- oder -CONR²- ersetzt sein können und wobei ein oder mehrere H-Atome durch F ersetzt sein können,
oder
ein aromatisches System mit 6 bis 30 C-Atomen, ein hetero-aromatisches System mit 2 bis 30 C-Atomen bzw. eine Aryloxy- oder Heteroaryloxygruppe der vorgenannten Systeme, welches jeweils durch einen oder mehrere Reste R¹ substituiert sein kann; dabei können auch zwei oder mehrere Reste R am selben Ring oder an unterschiedlichen Ringen miteinander ein weiteres aliphatisches oder aromatisches Ringsystem bilden.

11. Verbindungen gemäß mindestens einem der vorhergehenden Ansprüche, **dadurch gekennzeichnet, dass** Q für einen anionischen Substituenten steht.

12. Verbindungen gemäß Anspruch 11, **dadurch gekennzeichnet, dass** Q für einen oder mehrere Reste -B⁻(R)₃, -Al⁻(R)₃, -Ga⁻(R)₃, -In⁻(R)₃, -Tl⁻ (R)₃, -Si²⁻(R)₅, -Ge²⁻(R)₅, -Sn²⁻(R)₅, -Pb²⁻(R)₅, -R-O⁻, -R-S⁻, -R-COO⁻, -R-CSS⁻, -R-SO₃⁻, wobei der Rest R wie gemäß Anspruch 10 definiert ist, -COO', -CSS⁻, -O⁻, -S⁻, -Se⁻, -Te⁻, -SO₂-, -SO₃⁻, -SO₄²⁻, -PO₂²⁻, - PO₃²⁻, -PO₄²⁻, [PHal₅]⁻, [AsHal₅]⁻, [SbHal₅]⁻, wobei der Rest Hal für Chlor, Brom, lod, Fluor oder Pseudohalogenide, insbesondere SCN, CN oder OCN steht, AuCl₃-, PtCl₅²⁻, Fe(CN)₅^{2-/3-}, Polyelektrolyte und lonenaustauscherharze, insbesondere Polystyrolsulfate, steht.

13. Verbindungen gemäß mindestens einem der vorhergehenden Ansprüche, **dadurch gekennzeichnet, dass** Q in para-Position zur Bindung an das Metall M gebunden ist, insbesondere am Cyclus Cy1.

14. Verbindungen gemäß mindestens einem der vorhergehenden Ansprüche, **dadurch gekennzeichnet, dass** mehrere Reste R und/oder R¹ entweder am selben Cyclus oder an unterschiedlichen Cyclen ein oder mehrere aromatische oder aliphatische Ringsysteme bilden.

15. Verbindungen gemäß Anspruch 14, **dadurch gekennzeichnet, dass** zwischen den beiden Cyclen Cy1 und Cy2 eine Brücke vorliegt, die ein weiteres aromatisches oder aliphatisches Ringsystem aufspannt.

16. Verbindungen gemäß mindestens einem der vorhergehenden Ansprüche, **dadurch gekennzeichnet, dass** der Rest D für Stickstoff N steht.

17. Verbindungen gemäß mindestens einem der vorhergehenden Ansprüche, **dadurch gekennzeichnet, dass** der Rest X für = CR¹ oder N steht, insbesondere für den Rest = CR¹.

18. Verbindungen gemäß mindestens einem der vorhergehenden Ansprüche, **dadurch gekennzeichnet, dass** R¹ bei jedem Auftreten gleich oder verschieden H, F, CN, Methyl, tert-Butyl, Phenyl, CF₃ oder eine ankondensierte cyclische Alkoxygruppe mit 1 bis 4 C-Atomen ist.

19. Verbindungen gemäß mindestens einem der vorhergehenden Ansprüche, **dadurch gekennzeichnet, dass** mindestens einer der Substituenten R¹ eine Alkyl- und/oder Alkoxykette mit mindestens vier C-Atomen ist und/oder die Gruppe Q einen oder mehrere langkettige Reste R bzw. R¹ mit mindestens vier C-Atomen trägt.

20. Konjugierte, teilkonjugierte oder nicht-konjugierte Oligomere, Polymere oder Dendrimere, enthaltend eine oder mehrere der Verbindungen gemäß einem oder mehreren der Ansprüche 1 bis 19.

21. Lösungen enthaltend Verbindungen bzw. Oligomere, Polymere oder Dendrimere gemäß einem oder mehreren der Ansprüche 1 bis 20, bevorzugt enthaltend dipolar-aprotische oder dipolar-protische Lösemittel.

22. Verwendung von Verbindungen gemäß mindestens einem der Ansprüche 1 bis 19 oder den Oligomeren, Polymere und/oder Dendrimeren gemäß Anspruch 20 oder Lösungen gemäß Anspruch 21 in organischen elektronischen Bauteilen.

23. Organische elektronische Bauteile, enthaltend Verbindungen gemäß mindestens einem der Ansprüche 1 bis 19 oder den Oligomeren, Polymere und/oder Dendrimeren gemäß Anspruch 20.

24. Organische elektronische Vorrichtung gemäß Anspruch 23, ausgewählt aus der Gruppe der organischen und polymeren Leuchtdioden (OLEDs, PLEDs), elektrochemischen lichtemittierenden Zellen (LECs), organischen Feld-Effekt-Transistoren (O-FETs), organischen Dünnfilmtransistoren (O-TFTs), organischen integrierten Schaltungen (O-ICs), organischen Solarzellen (O-SCs), organische Feld-Quench-Devices (O-FQDs) und organischen Laserdioden (O-Laser).

## Claims

1. Ionic compounds of the formula (1)
[M(L)^{t+/t-}ₙ(L')ₘ(L")ₒ] [ion]^{t-/t+}ₙ formula (1)
containing a sub-structure M(L)^{t+/t-}ₙ of the formula (2) as cation or anion, 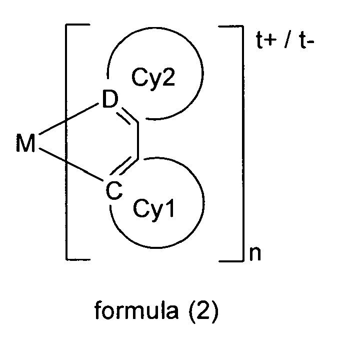 where the following applies to the symbols and indices used:
M is on each occurrence an element from the first to ninth sub- group of the Periodic Table of the Elements, preferably irid- ium, rhodium, platinum, palladium, gold, tungsten, rhenium, ruthenium or osmium;
D is, identically or differently on each occurrence, an sp²-hybrid- ised heteroatom having a non-bonding electron pair which coordinates to M;
C is on each occurrence an sp²-hybridised carbon atom which bonds to M;
Cy1 is, identically or differently on each occurrence, a homo- or heterocycle which bonds to M via an sp²-hybridised carbon atom and is optionally substituted by R¹ and/or Q; Cy1 here can be either a monocycle or an oligocycle;
Cy2 is, identically or differently on each occurrence, a heterocycle which coordinates to M via the atom D and is optionally sub- stituted by R¹ and/or Q; Cy2 here can be either a monocycle or an oligocycle;
Q is, identically or differently on each occurrence, a positively or negatively charged substituent having the number t of posi- tive or negative charges;
R¹ is, identically or differently on each occurrence, H, deuterium, F, Cl, Br, I, OH, NO₂, CN, N(R²)₂, B(OH)₂, B(OR²)₂, a straight- chain alkyl or alkoxy group having 1 to 40 C atoms, a branched or cyclic alkyl or alkoxy group having 3 to 40 C atoms, where one or more non-adjacent CH₂ groups in each of the above-mentioned alkyl or alkoxy groups may be re- placed by -R²C=CR²-, -C≡C-, Si(R²)₂, Ge(R²)₂, Sn(R²)₂, -O-, -S-, -NR²-, -(C=O)-, -(C=NR¹)-, -P=O(R²)-, -COOR²- or -CONR²- and where one or more H atoms may be replaced by F,
or
an aromatic system having 6 to 30 C atoms, a heteroaromatic system having 2 to 30 C atoms or an aryloxy or heteroaryloxy group of the above-mentioned systems, each of which may be substituted by one or more non-aromatic radicals R¹, where a plurality of substituents R¹, either on the same ring or on different rings, together may in turn define a further mono- or polycyclic, aliphatic or aromatic ring system;
R² is, identically or differently on each occurrence, H or an ali- phatic hydrocarbon radical having 1 to 20 C atoms or an aromatic hydrocarbon radical having 6 to 20 C atoms or a heteroaromatic hydrocarbon radical having 2 to 30 C atoms;
n is 1, 2 or 3;
t is 1, 2 or 3, preferably 1 or 2, in particular 1, where the ligand itself carries the charge;
the ligands L' and L" in formula (1) are monoanionic ligands which chelate in a bidentate manner; m and o are, identically or differently on each occurrence, 0, 1 or 2;
**characterised in that** at least one group Q is present on the structure of the formula (2);
and an ion which acts as counterion to the complex ion [M(L)^{t+/t-}ₙ(L')ₘ(L")ₒ].

2. Compounds according to Claim 1, **characterised in that** Cy1 and Cy2 are aromatic or heteroaromatic systems.

3. Compounds according to Claim 1, **characterised in that** Cy2 is a carbene which coordinates to the metal M via a carbon atom instead of via a heteroatom D.

4. Compounds according to Claim 1 or 2, **characterised in that** they contain at least one sub-structure M(L)^{t+/t-}ₙ of the formula (2a) 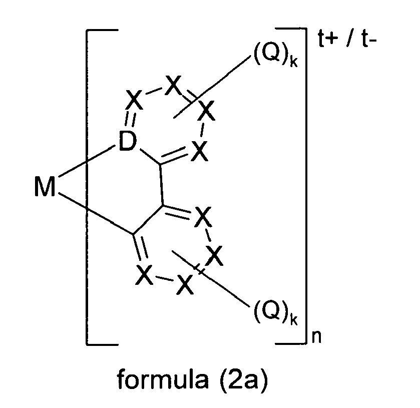 where M, R¹, R², L', L", n and t have the same meaning as described under Claim 1, and the following applies to the other symbols:
D is, identically or differently on each occurrence, nitrogen or phosphorus;
X is, identically or differently on each occurrence, CR¹, N or P; or
(X-X) or (X=X) (i.e. two adjacent X) stands for NR¹, S or O;
Q is, identically or differently on each occurrence, a positively or negatively charged substituent having the number t of posi- tive or negative charges or, in the case where the substituent only carries one positive or negative charge, is present k times, where k = t;
k is on each occurrence, identically or differently, 0, 1, 2, 3 or 4, where at least one index k in formula (2a) is not equal to 0;
with the proviso that each of the two rings represents a five- or six-membered ring.

5. Compounds according to at least one of the preceding claims, **characterised in that** they are compounds of the formula (1 a)
[M(L)^{t+/-}ₙ(L')ₘ(L")ₒ] [ion]^{t-/t+}ₙ formula (1a)
containing at least one sub-structure M(L)^{t+/t-}ₙ of the formula (2b) 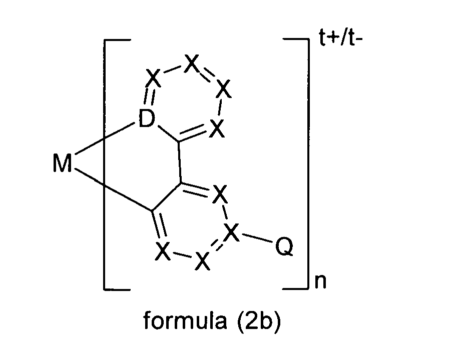 and optionally containing a sub-structure M(L')ₘ of the formula (3) 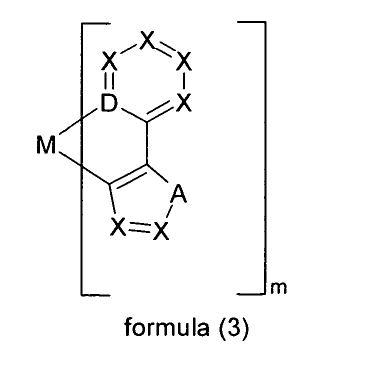 where M, D, X, R¹, R², L", Q, n, m, o and t have the same meaning as described under Claims 1 and 4, and furthermore:
A is, identically or differently on each occurrence, -CR¹=CR¹-, -N=CR¹-, -P=CR¹-, -N=N-, -P=N-, NR¹, O or S;
with the proviso that each of the two rings represents a five- or six-membered ring.

6. Compounds according to at least one of the preceding claims, **characterised in that** the ionic compounds of the formula (1) or (1a) are in the form of mixed salts.

7. Compounds according to Claim 6, **characterised in that** the compound of the formula (1) contains a sub-structure M(L)^{t+}ₙ of the formula (2) or (2a) with a cationic ligand, and the anion is formed from a sub-structure M(L)^{t-}ₙ of the formula (2) or (2a) with an anionic ligand as counterion.

8. Compounds according to Claim 4 or 5, **characterised in that** Q stands for a charged heterocyclic group based on pyridine, imidazole, thiazole, isothiazole, oxazole, isoxazole, quinoline, isoquinoline, pyridazine, pyrimidine, pyrazine, purine, phenazine or mixtures thereof, where the above-mentioned groups may carry one or more radicals R¹ as defined in Claim 1.

9. Compounds according to at least one of the preceding claims, **characterised in that** Q stands for a cationic substituent.

10. Compounds according to Claim 9, **characterised in that** Q stands for one or more radicals -N⁺(R)₃, -P⁺(R)₃, -As⁺(R)₃, -Sb⁺(R)₃, -Bi⁺(R)₃, -S⁺(R)₂, -Se⁺(R)₂, -Te⁺(R)₂ or a 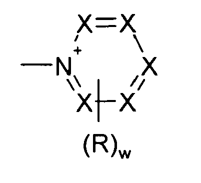 group, where w is an integer 1, 2, 3, 4 or 5, the symbol X is as defined in Claim 4, and the following applies to R:
R is, identically or differently on each occurrence, H, deuterium, F, CN, a straight-chain alkyl or alkoxy group having 1 to 40 C atoms, a branched or cyclic alkyl or alkoxy group having 3 to 40 C atoms, where one or more non-adjacent CH₂ groups in each of the above-mentioned alkyl or alkoxy groups may be replaced by -R²C=CR²-, -C≡C-, Si(R²)₂, Ge(R²)₂, Sn(R²)₂, -O-, -S-, -NR²-, -(C=O)-, -(C=NR²)-, -P=O(R²)- or -CONR²- and where one or more H atoms may be replaced by F,
or
an aromatic system having 6 to 30 C atoms, a heteroaromatic system having 2 to 30 C atoms or an aryloxy or heteroaryloxy group of the above-mentioned systems, each of which may be substituted by one or more radicals R¹; two or more radi- cals R on the same ring or on different rings may also form a further aliphatic or aromatic ring system with one another.

11. Compounds according to at least one of the preceding claims, **characterised in that** Q stands for an anionic substituent.

12. Compounds according to Claim 11, **characterised in that** Q stands for one or more radicals -B⁻(R)₃, -Al⁻(R)₃, -Ga⁻(R)₃, -In⁻(R)₃, -Tl⁻(R)₃, -Si²⁻(R)₅, -Ge²⁻(R)₅, -Sn²⁻(R)₅, -Pb²⁻(R)₅, -R-O⁻, -R-S⁻, -R-COO⁻, -R-CSS⁻, -R-SO₃⁻, where the radical R is as defined in Claim 10, -COO⁻, -CSS⁻, -O⁻, -S⁻, -Se⁻, -Te⁻, -SO₂⁻, -SO3⁻, -SO₄²⁻, -PO₂²⁻ -PO₃²⁻, -PO₄²⁻, [PHal₅]⁻, [AsHal₅]⁻, [SbHal₅]⁻, where the radical Hal stands for chlorine, bromine, iodine, fluorine or pseudohalides, in particular SCN, CN or OCN, AuCl₃⁻, PtCl₅²⁻, Fe(CN)₅^{2-/3-}, polyelectrolytes and ion exchanger resins, in particular polystyrene sulfates.

13. Compounds according to at least one of the preceding claims, **characterised in that** Q is bonded, in particular to the ring Cy1, in the para-position to the bond to the metal M.

14. Compounds according to at least one of the preceding claims, **characterised in that** a plurality of radicals R and/or R¹, either on the same ring or on different rings, form one or more aromatic or aliphatic ring systems.

15. Compounds according to Claim 14, **characterised in that** a bridge which defines a further aromatic or aliphatic ring system is present between the two rings Cy1 and Cy2.

16. Compounds according to at least one of the preceding claims, **characterised in that** the radical D stands for nitrogen N.

17. Compounds according to at least one of the preceding claims, **characterised in that** the radical X stands for CR¹ or N, in particular for the radical CR¹.

18. Compounds according to at least one of the preceding claims, **characterised in that** R¹ is on each occurrence, identically or differently, H, F, CN, methyl, tert-butyl, phenyl, CF₃ or a fused cyclic alkoxy group having 1 to 4 C atoms.

19. Compounds according to at least one of the preceding claims, **characterised in that** at least one of the substituents R¹ is an alkyl and/or alkoxy chain having at least four C atoms, and/or the group Q carries one or more long-chain radicals R or R¹ having at least four C atoms.

20. Conjugated, partially conjugated or non-conjugated oligomers, polymers or dendrimers comprising one or more of the compounds according to one or more of Claims 1 to 19.

21. Solutions comprising compounds or oligomers, polymers or dendrimers according to one or more of Claims 1 to 20, preferably comprising dipolar aprotic or dipolar protic solvents.

22. Use of compounds according to at least one of Claims 1 to 19 or the oligomers, polymers and/or dendrimers according to Claim 20 or solutions according to Claim 21 in organic electronic components.

23. Organic electronic components comprising compounds according to at least one of Claims 1 to 19 or the oligomers, polymers and/or dendrimers according to Claim 20.

24. Organic electronic device according to Claim 23, selected from the group of organic and polymeric light-emitting diodes (OLEDs, PLEDs), electrochemical light-emitting cells (LECs), organic field-effect transistors (O-FETs), organic thin-film transistors (O-TFTs), organic integrated circuits (O-ICs), organic solar cells (O-SCs), organic field-quench devices (O-FQDs) and organic laser diodes (O-lasers).

## Revendications

1. Composés ioniques de la formule (1)
M(L)^{t+/t-}ₙ(L')ₘ(L")ₒ] [ion]^{t-/t+}ₙ formule (1)
contenant une sous-structure M(L)^{t+/t-}ₙ de la formule (2) en tant que cation ou anion, 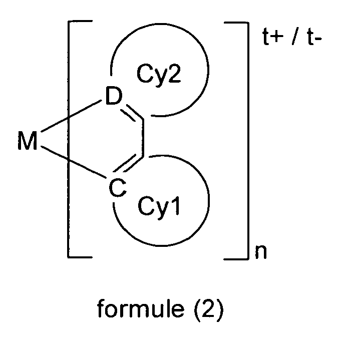 dans laquelle ce qui suit s'applique aux symboles et indices utilisés :
M est à chaque occurrence un élément pris parmi les premier à neuvième sous-groupes du Tableau Périodique des Elé- ments, de préférence iridium, rhodium, platine, palladium, or, tungstène, rhénium, ruthénium ou osmium ;
D est, de façon identique ou différente à chaque occurrence, un hétéroatome sp²-hybridisé ayant une paire d'électrons de non liaison qui se coordonne à M ;
C est à chaque occurrence un atome de carbone sp²-hybridisé qui se lie à M ;
Cy1 est, de façon identique ou différente à chaque occurrence, un homo- ou hétérocycle qui se lie à M via un atome de carbone sp²-hybridisé et qui est optionnellement substitué par R¹ et/ou Q ; Cy1 peut ici être soit un monocycle soit un oligo- cycle ;
Cy2 est, de façon identique ou différente à chaque occurrence, un hétérocycle qui se coordonne à M via l'atome D et qui est optionnellement substitué par R¹ et/ou Q ; Cy2 peut ici être soit un monocycle soit un oligocycle ;
Q est, de façon identique ou différente à chaque occurrence, un substituant chargé positivement ou négativement ayant le nombre t de charges positives ou négatives ;
R¹ est, de façon identique ou différente à chaque occurrence, H, deutérium, F, Cl, Br, I, OH, NO₂, CN, N(R²)₂, B(OH)₂, B(OR²)₂, un groupe alkyle ou alcoxy en chaîne droite ayant 1 à 40 atomes de C, un groupe alkyle ou alcoxy ramifié ou cyclique ayant 3 à 40 atomes de C, dans lequel un ou plu- sieurs groupes CH₂ non adjacents dans chacun des groupes alkyle ou alcoxy mentionnés ci-avant peuvent être remplacés par -R²C=CR²-, -C=C-, Si(R²)₂, Ge(R²)₂, Sn(R²)₂, -O-, -S-, -NR²-, -(C=O)-, -(C=NR¹)-, -P=O(R²)-, -COOR²- ou -CONR²- et dans lequel un ou plusieurs atomes de H peuvent être remplacés par F,
ou
un système aromatique ayant 6 à 30 atomes de C, un sys- tème hétéroaromatique ayant 2 à 30 atomes de C ou un groupe aryloxy ou hétéroaryloxy des systèmes mentionnés ci-avant, dont chacun peut être substitué par un ou plusieurs radicaux R¹ non aromatiques, dans lequel une pluralité de substituants R¹, soit sur le même cycle soit sur des cycles différents, peuvent ensemble à leur tour définir un autre sys- tème de cycle aliphatique ou aromatique, mono- ou poly- cyclique ;
R² est, de façon identique ou différente à chaque occurrence, H ou un radical hydrocarbone aliphatique ayant 1 à 20 atomes de C ou un radical hydrocarbone aromatique ayant 6 à 20 atomes de C ou un radical hydrocarbone hétéroaromatique ayant 2 à 30 atomes de C ;
n est 1, 2 ou 3 ;
t est 1, 2 ou 3, de préférence 1 ou 2, en particulier 1, dans lequel le ligand porte lui-même la charge ;
les ligands L'et L" dans la formule (1) sont des ligands mono-anioniques qui chélatent d'une manière bidentée ; m et o sont, de façon identique ou différente à chaque occurrence, 0, 1 ou 2 ; **caractérisés en ce qu'**au moins un groupe Q est présent sur la structure de la formule (2) ;
et un ion qui agit comme contre-ion sur l'ion complexe [M(L)^{t+/t-}ₙ(L')ₘ(L")ₒ].

2. Composés selon la revendication 1, **caractérisés en ce que** Cy1 et Cy2 sont des systèmes aromatiques ou hétéroaromatiques.

3. Composés selon la revendication 1, **caractérisés en ce que** Cy2 est un carbène qui se coordonne au métal M via un atome de carbone au lieu de via un hétéroatome D.

4. Composés selon la revendication 1 ou 2, **caractérisés en ce qu'**ils contiennent au moins une sous-structure M(L)^{t+/t-}ₙ de la formule (2a) 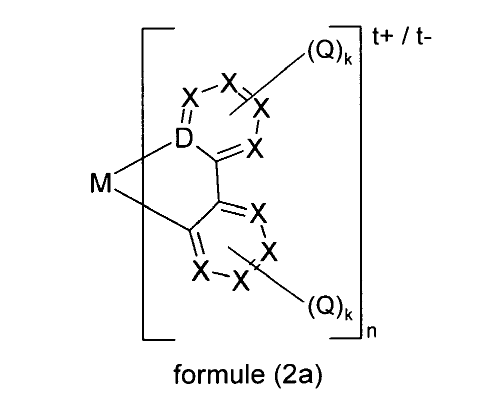 dans laquelle M, R¹, R², L', L", n et t ont la même signification que décrit sous la revendication 1, et ce qui suit s'applique aux autres symboles :
D est, de façon identique ou différente à chaque occurrence, azote ou phosphore ;
X est, de façon identique ou différente à chaque occurrence, CR¹, N ou P; ou
(X-X) ou (X=X) (c'est-à-dire deux X adjacents) représente NR¹, S ou O ;
Q est, de façon identique ou différente à chaque occurrence, un substituant chargé positivement ou négativement ayant le nombre t de charges positives ou négatives ou, dans le cas où le substituant porte seulement une seule charge positive ou négative, est présent k fois, dans lequel k = t ;
k est à chaque occurrence, de façon identique ou différente, 0, 1, 2, 3 ou 4, dans lequel au moins un indice k dans la formule (2a) n'est pas égal à 0 ;
sous la réserve que chacun des deux cycles représente un cycle à cinq ou six membres.

5. Composés selon au moins une des revendications précédentes, **caractérisés en ce qu'**ils sont des composés de la formule (1a)
[M(L)^{t+/-}ₙ(L')ₘ(L'')ₒ] [ion]^{t-/t+}ₙ formule (1a)
contenant au moins une sous-structure M(L)^{t+/t-}ₙ de la formule (2b) 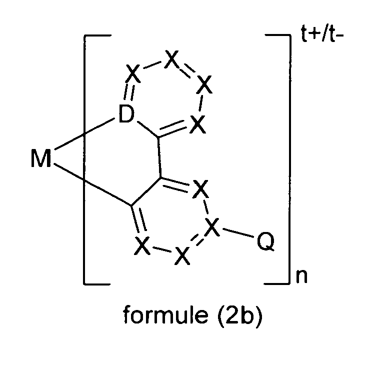 et contenant optionnellement une sous-structure M(L')ₘ de la formule (3) 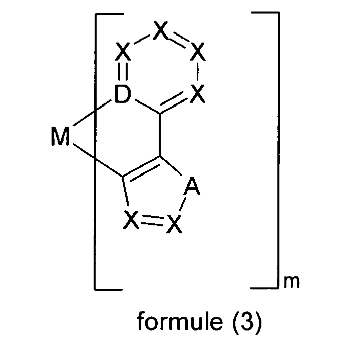 dans laquelle M, D, X, R¹, R², L", Q, n, m, o et t ont la même signification que décrit sous les revendications 1 et 4, et en outre :
A est, de façon identique ou différente à chaque occurrence, -CR¹=CR¹- -N=CR¹-, -P=CR¹-, -N=N-, -P=N-, NR¹, O ou S;
sous la réserve que chacun des deux cycles représente un cycle à cinq ou six membres.

6. Composés selon au moins une des revendications précédentes, **caractérisés en ce que** les composés ioniques de la formule (1) ou (1a) sont sous la forme de sels mixtes.

7. Composés selon la revendication 6, **caractérisés en ce que** le composé de la formule (1) contient une sous-structure M(L)^{t+}ₙ de la formule (2) ou (2a) avec un ligand cationique, et l'anion est formé à partir d'une sous-structure M(L)^{t-}ₙ de la formule (2) ou (2a) avec un ligand anionique comme contre-ion.

8. Composés selon la revendication 4 ou 5, **caractérisés en ce que** Q représente un groupe hétérocyclique chargé basé sur pyridine, imidazole, thiazole, isothiazole, oxazole, isoxazole, quinoline, isoquinoline, pyridazine, pyrimidine, pyrazine, purine, phénazine ou des mélanges de ceux-ci, dans lequel les groupes mentionnés ci-avant peuvent porter un ou plusieurs radicaux R¹ comme définis dans la revendication 1.

9. Composés selon au moins une des revendications précédentes, **caractérisés en ce que** Q représente un substituant cationique.

10. Composés selon la revendication 9, **caractérisés en ce que** Q représente un ou plusieurs radicaux -N⁺(R)₃, -P⁺(R)₃, -As⁺(R)₃, -Sb⁺(R)₃, -Bi⁺(R)₃, -S⁺(R)₂, -Se⁺(R)₂, -Te⁺(R)₂ ou un groupe 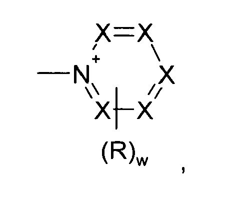 dans lequel w est un entier 1, 2, 3, 4 ou 5, le symbole X est comme défini dans la revendication 4, et ce qui suit s'applique à R :
R est, de façon identique ou différente à chaque occurrence, H, deutérium, F, CN, un groupe alkyle ou alcoxy en chaîne droite ayant 1 à 40 atomes de C, un groupe alkyle ou alcoxy ramifié ou cyclique ayant 3 à 40 atomes de C, dans lequel un ou plusieurs groupes CH₂ non adjacents dans chacun des groupes alkyle ou alcoxy mentionnés ci-avant peuvent être remplacés par -R²C=CR²-, -C=C-, Si(R²)₂, Ge(R²)₂, Sn(R²)₂, -O-, -S-, -NR²-, -(C=O)-, -(C=NR²)-, -P=O(R²)- ou -CONR²- et dans lequel un ou plusieurs atomes de H peuvent être rem- placés par F,
ou
un système aromatique ayant 6 à 30 atomes de C, un sys- tème hétéroaromatique ayant 2 à 30 atomes de C ou un groupe aryloxy ou hétéroaryloxy des systèmes mentionnés ci-avant, dont chacun peut être substitué par un ou plusieurs radicaux R¹ ; deux radicaux R ou plus sur le même cycle ou sur des cycles différents peuvent également former un autre système de cycle aliphatique ou aromatique avec un autre.

11. Composés selon au moins une des revendications précédentes, **caractérisés en ce que** Q représente un substituant anionique.

12. Composés selon la revendication 11, **caractérisés en ce que** Q représente un ou plusieurs radicaux -B⁻(R)₃, -Al⁻(R)₃, -Ga⁻(R)₃, -In⁻(R)₃, -TI⁻ (R)₃, -Si²⁻(R)₅, -Ge²⁻(R)₅, -Sn²⁻(R)₅, -Pb²⁻(R)₅, -R-O⁻, -R-S⁻, -R-COO⁻, -R-CSS⁻, -R-SO₃⁻, dans lequel le radical R est comme défini dans la revendication 10, -COO⁻, -CSS⁻, -O-, -S⁻, -Se-, -Te⁻, -SO₂⁻, -SO₃⁻, -SO₄²⁻, -PO₂²⁻, -PO₃²⁻, -PO₄²⁻, [PHal₅]⁻, [AsHal₅]⁻, [SbHal₅]⁻, dans lequel le radical Hal représente chlore, brome, iode, fluor ou des pseudohalogénures, en particulier SCN, CN ou OCN, AuCl₃⁻, PtCl₅²⁻, Fe(CN)₅^{2-/3-}, des polyélectrolytes des résines échangeuses d'ions, en particulier des sulfates de polystyrène.

13. Composés selon au moins une des revendications précédentes, **caractérisés en ce que** Q est lié, en particulier au cycle Cy1, dans la para-position à la liaison au métal M.

14. Composés selon au moins une des revendications précédentes, **caractérisés en ce qu'**une pluralité de radicaux R et/ou R¹, soit sur le même cycle soit sur des cycles différents, forment un ou plusieurs systèmes de cycle aromatique ou aliphatique.

15. Composés selon la revendication 14, **caractérisés en ce qu'**un pont qui définit un autre système de cycle aromatique ou aliphatique est présent entre les deux cycles Cy1 et Cy2.

16. Composés selon au moins une des revendications précédentes, **caractérisés en ce que** le radical D représente azote N.

17. Composés selon au moins une des revendications précédentes, **caractérisés en ce que** le radical X représente CR¹ ou N, en particulier le radical CR¹.

18. Composés selon au moins une des revendications précédentes, **caractérisés en ce que** R¹ est à chaque occurrence, de façon identique ou différente, H, F, CN, méthyle, tert-butyle, phényle, CF₃ ou un groupe alcoxy cyclique fusionné ayant 1 à 4 atomes de C.

19. Composés selon au moins une des revendications précédentes, **caractérisés en ce qu'**au moins un des substituants R¹ est une chaîne alkyle et/ou alcoxy ayant au moins quatre atomes de C, et/ou le groupe Q porte un ou plusieurs radicaux en chaîne longue R ou R¹ ayant au moins quatre atomes de C.

20. Oligomères, polymères ou dendrimères conjugués, partiellement conjugués ou non conjugués comprenant un ou plusieurs des composés selon une ou plusieurs des revendications 1 à 19.

21. Solutions comprenant des composés ou oligomères, polymères ou dendrimères selon une ou plusieurs des revendications 1 à 20, comprenant de préférence des solvants aprotiques dipolaires ou protiques dipolaires.

22. Utilisation de composés selon au moins une des revendications 1 à 19 ou les oligomères, polymères et/ou dendrimères selon la revendication 20 ou solutions selon la revendication 21 dans des composants électroniques organiques.

23. Composants électroniques organiques comprenant des composés selon au moins une des revendications 1 à 19 ou les oligomères, polymères et/ou dendrimères selon la revendication 20.

24. Dispositif électronique organique selon la revendication 23, choisi parmi le groupe des diodes émettrices de lumière organiques et polymériques (OLEDs, PLEDs), des cellules émettrices de lumière électrochimiques (LECs), des transistors à effet de champ organiques (O-FETs), des transistors en film mince organiques (O-TFTs), des circuits intégrés organiques (O-ICs), des cellules solaires organiques (O-SCs), des dispositifs à extinction de champ organiques (O-FQDs) et des diodes laser organiques (O-lasers).
